(19) Europäisches Patentamt
European Patent Office
Office européen des brevets

(11) **EP 4 115 528 B1**

(12) **EUROPÄISCHE PATENTSCHRIFT**

(45) Veröffentlichungstag und Bekanntmachung des Hinweises auf die Patenterteilung:
**03.06.2026 Patentblatt 2026/23**

(21) Anmeldenummer: **21705495.6**

(22) Anmeldetag: **12.02.2021**

(51) Internationale Patentklassifikation (IPC):
*H03M 7/30* (2006.01)   *B60W 30/00* (2006.01)
*G06F 13/00* (2006.01)   *G08G 1/00* (2006.01)
*H03M 7/24* (2006.01)

(52) Gemeinsame Patentklassifikation (CPC):
**H03M 7/3059; H03M 7/70;** G08G 1/0112;
H03M 7/24

(86) Internationale Anmeldenummer:
**PCT/EP2021/053473**

(87) Internationale Veröffentlichungsnummer:
**WO 2021/175568 (10.09.2021 Gazette 2021/36)**

(54) **VERFAHREN ZUR AUFBEREITUNG VON WENIGSTENS EINE ZEITREIHE ENTHALTENDEN DATENSÄTZEN, VORRICHTUNG ZUR DURCHFÜHRUNG, FAHRZEUG SOWIE COMPUTERPROGRAMM**

METHOD FOR PROCESSING DATA SETS CONTAINING AT LEAST ONE TIME SERIES, DEVICE FOR CARRYING OUT, VEHICLE AND COMPUTER PROGRAM

PROCÉDÉ DE TRAITEMENT D'ENSEMBLES DE DONNÉES CONTENANT AU MOINS UNE SÉRIE CHRONOLOGIQUE, DISPOSITIF DE MISE EN ?UVRE, VÉHICULE ET PROGRAMME INFORMATIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.03.2020 DE 102020202625**

(43) Veröffentlichungstag der Anmeldung:
**11.01.2023 Patentblatt 2023/02**

(73) Patentinhaber: **VOLKSWAGEN AKTIENGESELLSCHAFT**
**38440 Wolfsburg (DE)**

(72) Erfinder:
• **PIEWEK, Jan**
  **39128 Magdeburg (DE)**
• **JONAS, Konstantin**
  **10829 Berlin (DE)**

(56) Entgegenhaltungen:
EP-A2- 2 945 290     JP-A- H06 152 417
US-A1- 2009 300 039   US-B1- 7 245 247
US-B1- 9 520 894     US-B2- 7 224 294

• ANONYMOUS: "Compact disc", WIKIPEDIA, 1 March 2020 (2020-03-01), pages 1 - 18, XP055796154, Retrieved from the Internet <URL:https://en.wikipedia.org/w/index.php?title=Compact_disc&oldid=943322495> [retrieved on 20210416]
• BLASZCZAK-BAK WIOLETA ET AL: "Down-Sampling of Large LiDAR Dataset in the Context of Off-Road Objects Extraction", GEOSCIENCES, vol. 10, no. 6, 4 June 2020 (2020-06-04), pages 219, XP055796264, DOI: 10.3390/geosciences10060219
• ANONYMOUS: "Box plot", WIKIPEDIA, 24 December 2020 (2020-12-24), pages 1 - 8, XP055797148, Retrieved from the Internet <URL:https://en.wikipedia.org/w/index.php?title=Box_plot&oldid=996143328> [retrieved on 20210420]

EP 4 115 528 B1

- ANONYM: "Floating Point to Integer Mapping, MISB ST 1201.1", MOTION IMAGERY STANDARDS BOARD, 27 February 2014 (2014-02-27), pages 1 - 20, XP055797141, Retrieved from the Internet <URL:https://gwg.nga.mil/misb/docs/standards/ST1201.1.pdf> [retrieved on 20210420]
- ANONYMOUS: "Downsampling (signal processing)", WIKIPEDIA, 1 March 2020 (2020-03-01), pages 1 - 5, XP055796148, Retrieved from the Internet <URL:https://en.wikipedia.org/w/index.php?title=Downsampling_(signal_processing)&oldid=943354289> [retrieved on 20210416]
- ANONYMOUS ET AL: "Compression by Scaling and Offfset", 4 September 2014 (2014-09-04), pages 1 - 6, XP055797103, Retrieved from the Internet <URL:https://www.unidata.ucar.edu/blogs/developer/entry/compression_by_scaling_and_offfset> [retrieved on 20210420]
- ANONYMOUS: "Box plot", WIKIPEDIA, 1 March 2020 (2020-03-01), pages 1 - 8, XP055797206, Retrieved from the Internet <URL:https://en.wikipedia.org/w/index.php?title=Box_plot&oldid=943309261> [retrieved on 20210420]

**Beschreibung**

Die Erfindung betrifft das technische Gebiet der Datenkompression und Datenanalyse. Auch in Fahrzeugen werden zunehmend mehr Daten erfasst und zu externen Rechenzentren übertragen wo die Datenanalyse durchgeführt werden kann. Die Erfindung betrifft weiterhin eine entsprechend ausgelegte Vorrichtung zur Datenkompression und/oder Datenanalyse sowie ein Fahrzeug, das mit einer entsprechenden Vorrichtung ausgestattet ist und ein entsprechend ausgelegtes Computerprogramm.

Mit der Entwicklung neuerer Technologien für den Individualverkehr bis hin zum autonomen Fahren ist für die nahe Zukunft davon auszugehen, dass systemseitig durch den Einsatz von Datenbanken, verbesserter Fahrzeugsensorik, etc. immer mehr Daten zwischen Fahrzeugen und zwischen Fahrzeug und Rechenzentrum ausgetauscht werden müssen. Dies erfordert einen massiven Ausbau der Kommunikationsnetze, da die Fahrzeuge untereinander über Fahrzeug-zu Fahrzeug-Kommunikation V2V aber auch zu Backend-Servern über Fahrzeug zu Infrastruktur-Kommunikation V2X immer mehr Daten austauschen müssen.

Aus Fahrzeugen werden also zunehmend mehr Daten in die "Cloud" übertragen. Die zur Verfügung stehende Bandbreite für die V2X-Kommunikation ist begrenzt. Daher besteht ein Ansatz, um diesen Konflikt zu lösen, darin, die Daten im Fahrzeug zu komprimieren und nur noch die komprimierten Daten an einen Backend-Server (in der "Cloud") zu übertragen.

Ein bekanntes Kompressionsverfahren, das dafür eingesetzt wird, ist das ZIP-Verfahren, mit denen die großen Datensätze beliebiger Daten verlustfrei, komprimiert werden können.

Aus der US 2018/253559 A1 ist ein Verfahren zur verlustlosen Nutzlastkomprimierung bekannt. Für die Nutzlastkomprimierung wird Entropie-Codierung, wie Huffman-Codierung und LZ77, entsprechend Lempel-Ziv 77, eingesetzt. In einer Variante erfolgt das Verschlüsseln ausgewählter Teile der Nutzlast in einem Datenblock nach AES-Verfahren, entsprechend Advanced Encryption Standard mit Huffman-codierten Angaben, die den Beginn und das Ende von Verschlüsselungsgrenzen angeben. Dies ermöglicht die selektive Übernahme eines höheren Maßes an Sicherheit, wie es in bestimmten Anwendungen gewünscht wird.

Die bekannten Lösungen sind mit einem Nachteil behaftet. Dies wurde im Rahmen der Erfindung erkannt. Bei den bekannten Lösungen besteht das Problem, dass diese zwar die Komprimierung der Rohdaten ermöglichen, so dass für die Abspeicherung der komprimierten Daten weniger Speicherplatz benötigt wird, und für die Übertragung der komprimierten Daten auch weniger Bandbreite des benutzten Kommunikationssystems benötigt wird, eine Analyse der komprimierten Daten aber mit Aufwand verbunden ist. Dafür ist es nämlich erforderlich einen Schritt der Dekomprimierung der Daten durchzuführen, bevor die Analyse möglich wird. Bei großen Datensätzen, die z.B. für die Anwendung im Fahrzeug oder bei Maschinen und Anlagen über die gesamte Betriebszeit gesammelt werden, kann dies zu beträchtlichem Zusatzaufwand führen. Wird die Analyse der Daten in dem Backend-Server durchgeführt, steht oft genug Rechenleistung zur Verfügung um die Dekomprimierung neben den anderen Aufgaben des Servers zu erledigen. Trotzdem verursacht dies auch Kosten. Anders sieht es aber aus, wenn die Analyse selbst auch in dem Fahrzeug oder der Maschine durchgeführt werden soll. Für die Anwendung im Fahrzeug oder auch bei einer Maschine ist es zum Beispiel nötig den Verschleißzustand von Verschleißteilen während des Betriebes zu überwachen. Hier soll dem Fahrer oder dem Maschinenführer möglichst aktuell eine Information bzgl. der Notwendigkeit einer Wartung ausgegeben werden. Bei sicherheitsrelevanten Verschleißteilen ist dies unbedingt erforderlich. Im Fahrzeug werden aber elektronische Steuergeräte eingesetzt, die mit Mikrocontrollern ausgestattet sind, deren Rechenleistung begrenzt ist. Als Massenprodukte sind die Steuergeräte auch einem erhöhten Preisdruck ausgesetzt. Außerdem arbeiten die Steuergeräte unter Echtzeitbedingungen, so dass bestimmte Datenanalyseverfahren, deren Rechenaufwand mindestens linear von der Anzahl der zu analysierenden Datenpunkte abhängt, nicht oder nur mit zusätzlicher Rechenleistung ausführbar sind. Eine Beschränkung könnte sich auch aus der Notwendigkeit ergeben, dass die Daten über ein internes Kommunikationsnetzwerk im Fahrzeug übertragen werden müssen, dessen Bandbreite begrenzt ist. Hinzu kommt, dass die rekonstruierten Daten bestenfalls die gleiche Größe wie die Rohdaten haben. Im Fall von 1 Bit großen Statussignalen (z.B. Fahrertür Zu/Auf) die über ein Kommunikationsnetzwerk des Fahrzeuges, wie den CAN-Bus (Controller Area Network) übertragen werden, bedeutet eine Analyse mit dem Fließkomma-Datentyp "Double, 64 Bit" eine Speicherzunahme um den Faktor 64 gegenüber der originalen Größe, bzw. eine Speicherzunahme um den Faktor 8 gegenüber einer "8 Bit Unsigned Integer"-Darstellung. Die Implementierung und Ausführung des Kompressionsalgorithmus in einem Steuergerät eines Fahrzeugs benötigt Festspeicher für den Programmcode, flüchtigen Speicher für die Variablen zur Laufzeit und Rechenzeit. Einige Kompressionsverfahren scheiden auf Grund Ihres Ressourcenbedarfs zur Anwendung in einem Steuergerät aus, bzw. es können mit Ihnen nur wenige Signale komprimiert werden.

Aber auch für "Cloud-Anwendungen" wird es interessant den Aufwand für die Datenanalyse zu verringern. Bei der Anwendung im Fahrzeugbereich werden die Rohdaten im Fahrzeug komprimiert und auf der Backend-Server-Seite wieder dekomprimiert. Bei Großserien-Fahrzeugherstellern fallen riesige Datenmengen an, die im Backend gespeichert und verarbeitet werden müssen. Wenn mehrere Millionen Fahrzeuge pro Jahr gefertigt werden, ist leicht vorstellbar, dass immense Rechenzentren aufgebaut werden müssen, um all diese Daten speichern und verarbeiten zu können. Auch dafür kann es von Vorteil sein, wenn der benötigte Aufwand begrenzt werden kann.

Aus der US 9,520,894 B1 ist ein Signalkodierungs- und -komprimierungssystem mit dynamischer Unterabtastung bekannt. Das System enthält ein Kodierungsmodul, das so konfiguriert ist, dass es ein erstes digitales Signal dezimiert und dadurch ein zweites digitales Signal erzeugt. Jedes Signal wird dann DPCM-kodiert. Mit Hilfe einer Entscheidungslogik wird auf der Grundlage einer Eigenschaft des ursprünglichen Signals bestimmt, welches kodierte Signal als Ausgangssignal bereitgestellt werden soll.

Weiterhin sind aus der EP 2 645 318 A1 und der EP 3 522 577 A1 Verfahren bekannt, bei denen aufeinanderfolgende aufgezeichnete Datenwerte nur dann dauerhaft gespeichert oder an einen Leitrechner übertragen werden, wenn eine Differenz zum zuletzt gespeicherten/übertragenen Datenwert größer ist als ein vorgegebener Schwellenwert.

Es besteht deshalb der Bedarf für die Entwicklung eines verbesserten Kompressionsalgorithmus, der mit weniger Ressourcen auskommt und variabel einstellbar ist, was den Kompressionsgrad und die Verlustrate anbelangt und wobei der Aufwand für die Dekomprimierung bzw. Datenanalyse reduziert ist. Dies ist Aufgabe der Erfindung.

Diese Aufgabe wird durch ein Verfahren zur Aufbereitung von wenigstens eine Zeitreihe enthaltenden Datensätzen gemäß Anspruch 1, eine Vorrichtung zur Durchführung des Verfahrens gemäß Anspruch 9 und 12, ein Fahrzeug gemäß Anspruch 11 sowie ein Computerprogramm gemäß Anspruch 13 gelöst.

Die abhängigen Ansprüche beinhalten vorteilhafte Weiterbildungen und Verbesserungen der Erfindung entsprechend der nachfolgenden Beschreibung dieser Maßnahmen.

In einer allgemeinen Ausprägung betrifft die Erfindung ein Verfahren zur Aufbereitung von wenigstens eine Zeitreihe enthaltenden Datensätzen durch eine Recheneinheit, wobei die Zeitreihe die zu bestimmten Zeitpunkten erfassten Daten und den jeweiligen Zeitpunkt der Datenerfassung als Datenelemente enthält. Der Zeitpunkt der Datenerfassung kann dabei zum Beispiel als eine absolute Zeit dargestellt werden oder als eine Deltazeit zu einem absoluten Zeitpunkt oder als Index im Falle einer zeitlich äquidistanten Datenaufzeichnung. Diese Datensätze werden nach dem Verfahren in einer besonderen Art und Weise komprimiert, bei dem ein Schritt einer Rundung der erfassten Daten mit einer nachfolgenden Dezimierung der in der wenigstens einen Zeitreihe enthaltenen Datenelemente des Datensatzes durchgeführt wird und die dezimierte Zeitreihe des Datensatzes in der Recheneinheit abgespeichert und/oder an eine externe Recheneinrichtung übertragen wird. Das Datenkompressionsverfahren bietet die aus anderen bekannten Datenkompressionsverfahren bekannten Vorteile wie Verringerung der zu speichernden oder zu übertragenden Datenmenge. Zusätzlich bietet das Verfahren aber noch den besonderen Vorteil, dass eine Datenanalyse an dem komprimierten Datensatz möglich wird, ohne einen Dekompressionsalgorithmus durchführen zu müssen. Dies stellt einen beträchtlichen Vorteil dar, da die Daten häufig nicht nur archiviert werden müssen, sondern auch zu Wartungszwecken, zur Erkennung sicherheitskritischer Entwicklungen, zur Anpassung von Funktionen an die persönlichen Verhaltensweisen und Vorlieben des Benutzers, ggfs. zu Garantiezwecken und zur Ermittlung von Unfallhergängen analysiert werden müssen.

Konkret besteht eine erfindungsgemäße Lösung für den Schritt der Dezimierung darin, dass Datenelemente, deren gerundetes Datum sich nicht vom gerundeten Datum des direkten zeitlichen Vorgängers unterscheidet, entfernt werden. Damit können bei vielen Zeitreihen, bei denen sich der erfasste Messwert kaum ändert, hohe Kompressionsraten von >10 erzielt werden.

Ein häufiger Anwendungsfall besteht darin, dass die Zeitreihe einer Messwertreihe entspricht, wobei die Messwerte als Integer-Zahlen erfasst werden oder als Gleitkommazahlen erfasst werden. Hier ist es für das Kompressionsverfahren vorteilhaft, wenn ein Schritt der Umwandlung in Integer-Zahlen durchgeführt wird, bevor das Kompressionsverfahren angewendet wird.

Dafür ist es vorteilhaft, wenn zur Umwandlung in Integer-Zahlen die Nachkommastellen der Gleitkommazahlen der Datenelemente der Zeitreihe durch Kommaverschiebung in ganzzahlige Dezimalzahlen umgewandelt werden, die dann in einem weiteren Schritt in Integer-Zahlen umgewandelt werden.

Zusätzlich ist es vorteilhaft, wenn zur Vorbereitung für die Dezimierung der Datenelemente der Zeitreihe ein Algorithmus durchgeführt wird, der eine Rundung der Integer-Zahlen vornimmt. Hierbei kann vorgegeben werden wie stark sich die Rundung auswirken soll. Dies hat entscheidenden Einfluss auf den Kompressionsgrad.

In einer besonders vorteilhaften Variante wird die Rundungsoperation nach folgender Vorschrift vorbereitet:

$$rnd(x) = AND(BSR(int(x), nbit-1), 1)$$

wobei $rnd(x)$ einer Rundungsinformation der Integerzahl entspricht, die für eine nachfolgende Rundungsoperation ausgewählt wird, wobei $x$ einem Datenelementindex entspricht, wobei $int(x)$ der Integerzahl entspricht, wobei $nbit-1$ angibt welche Bitstelle der Integerzahl für die Berechnung der Rundungsinformation $rnd(x)$ nach der genannten Vorschrift gewählt werden soll, wobei AND einer logischen UND-Operation des Eintrages an der durch Rechtsverschiebung (BSR-Funktion) um die Anzahl $nbit-1$ Bitstellen der Integerzahl $int(x)$ bestimmten Bitstelle mit dem Integerwert "1" entspricht. Mit Wahl des Parameters $nbit$ kann der Kompressionsgrad eingestellt werden.

Die eigentliche Rundungsoperation kann in vorteilhafter Weise nach folgender Vorschrift durchgeführt werden:

$$comp(x) = BSR(int(x), nbit)+rnd(x),$$

wobei comp(x) der durch die Rundung entstehende auflösungsreduzierte Anteil der Integerzahl int(x) entspricht, wobei nbit der Angabe entspricht um wie viele Bitstellen die Integerzahl nach rechts verschoben werden soll, bevor die Addition mit der Rundungsinformation rnd(x) durchgeführt wird. Mit der Wahl des Parameters nbit = 0 kann der Kompressionsalgorithmus auf verlustfreie Kompression eingestellt werden. In diesem Fall muss die Rundungsinformation rnd(x) nicht berechnet werden, da sie Null ist.

Nach diesen Vorbereitungsschritten kann die Dezimierung der Datenelemente des Datensatzes erfolgen. Dafür ist es vorteilhaft, wenn die gerundeten Werte comp(x) und comp(x+1) miteinander verglichen werden und das Datenelement eines nachfolgenden identischen Wertes comp(x+1) aus der Zeitreihe weggelassen wird. So können bei immer wiederkehrenden Daten diese Datenelemente aus dem Datensatz eliminiert werden, was eine hohe Kompression bewirkt.

Der Kompressionsalgorithmus kann auch direkt in einer Floating-Point-Darstellung der Daten ausgeführt werden. Dann wird die Floating-Point-Zahl durch das kleinste unterscheidbare Inkrement in der reduzierten Darstellung dividiert, anschließend gerundet und dann wieder mit dem kleinsten unterscheidbaren Inkrement in der reduzierten Darstellung multipliziert. In der Regel ist die Ausführungszeit in der Integer-Darstellung geringer als in der Floating-Point-Darstellung, so dass bevorzugt die Integer-Implementierung genutzt wird.

In einer weiteren Ausführungsvariante kann der zuvor beschriebene Kompressionsalgorithmus in zeitlichen Fenstern ausgeführt werden. Die zeitlichen Fenster können zum Beispiel eine feste Länge von 1s aufweisen oder aber auch durch externe Ereignisse wie zum Beispiel "Öffnen des Fahrzeugs" oder "Abschließen des Fahrzeugs" gestartet oder beendet werden. Typischerweise startet ein neues Fenster direkt nach dem Abschluss des vorangehenden Fensters. Ein konstantes Signal ist dann zum Beispiel in jedem Fenster mit einem Datenelement enthalten.

Die Fensterlänge definiert dabei sowohl die maximal erreichbare Kompressionsrate als auch die Häufigkeit, mit der ein komprimierter Datensatz übertragen wird. Längere Fenster bedingen dabei eine höhere maximale Kompressionsrate.

Der komprimierte Datensatz kann in der Recheneinheit, in der die Kompression durchgeführt wurde, abgespeichert werden. Wenn die Analyse der Daten an einer externen Stelle durchgeführt werden soll, besteht eine weitere vorteilhafte Maßnahme des Verfahrens darin den komprimierten Datensatz von der Vorrichtung, in der der Datensatz komprimiert wurde, an eine externe Recheneinrichtung übertragen wird.

Dies kann vorteilhaft mit Hilfe eines öffentlichen, zellularen Mobilfunkkommunikationssystems oder einem anderen Mobilfunkkommunikationssystem durchgeführt werden. Mit Einführung des 5G Mobilfunkkommunikationssystems werden immer mehr Fahrzeuge, Maschinen und Anlagen darüber an das Internet angebunden. Als Beispiel eines anderen Mobilfunkkommunikationssystems wird das ebenfalls für die V2V-Kommunikation und V2X-Kommunikation spezifizierte WLAN p-System nach dem Standard IEEE 802.11p genannt.

Zur Datenanalyse ist es besonders vorteilhaft, wenn die Analyse der dezimierten Zeitreihe des Datensatzes durchgeführt wird, ohne eine Dekompression des Datensatzes vornehmen zu müssen.

Dies kann für eine Box-Plot-Analyse des komprimierten Datensatzes so durchgeführt werden, dass die dezimierte Zeitreihe nach aufsteigender Größe der auflösungsreduzierten comp(x)-Information sortiert wird und die Kennwerte der Box-Plot-Analyse, insbesondere Minimumwert, Maximalwert, Medianwert, unteres Quartil und oberes Quartil unter Berücksichtigung der Zeitdifferenz zum jeweils nächsten Datenelement aus dem komprimierten Datensatz selektiert werden.

Es ist möglich, dass Datenkompression und Datenanalyse in einer gemeinsamen Vorrichtung oder in getrennten Vorrichtungen durchgeführt werden.

Für eine Vorrichtung zur Durchführung des Verfahrens ist es vorteilhaft, dass die Vorrichtung wenigstens eine Recheneinheit aufweist, die ausgelegt ist zu aufeinanderfolgenden Zeitpunkten eine Messwerterfassung wenigstens eines angeschlossenen Sensors durchzuführen oder die vom Sensor erfassten Messwerte zu empfangen. Zusätzlich ist es vorteilhaft, wenn die Recheneinheit ausgelegt ist mit den Messwerten und zugehörigen Messzeitpunkten eine Zeitreihe zu bilden, und weiter wenigstens den Schritt einer Rundung mit einer nachfolgenden Dezimierung der in der wenigstens einen Zeitreihe enthaltenen Messwerte der Datenelemente des Datensatzes durchzuführen. Besonders im Fahrzeug ist es möglich, dass ein Sensor nicht direkt an eine Vorrichtung zur Durchführung des Verfahrens angeschlossen ist, sondern über einen Kommunikationsbus, z.B. CAN-Bus die Daten regelmäßig an eine Vorrichtung zur Durchführung des Verfahrens überträgt. Dies kann aber auch in anderen Anwendungsbereichen so erfolgen. Als weiteres Beispiel wird die Automatisierungstechnik genannt, bei der Sensoren an ein Feldbussystem angeschlossen werden können. Es muss sich nicht unbedingt um Messwerte von Sensoren handeln. Zeitreihen können auch mit Rechenergebnissen aufgestellt werden, die als Dateninhalte von Speicherzellen im Speicher von Recheneinheiten archiviert werden, also letztlich jede digital vorliegende Information in dem Fahrzeug. Als ein Beispiel wird der berechnete Durchschnittsverbrauch des Fahrzeuges erwähnt.

Es ist weiterhin vorteilhaft, wenn die Recheneinrichtung oder eine weitere Recheneinrichtung der Vorrichtung ausgelegt ist eine Box-Plot-Analyse des komprimierten Datensatzes durchzuführen, indem die dezimierte Zeitreihe nach aufsteigender Größe der auflösungsreduzierten comp(x)-Information sortiert wird und die Kennwerte der Box-Plot-Analyse, insbesondere Minimumwert, Maximalwert, Medianwert, unteres Quartil und oberes Quartil, unter Berücksichtigung der Zeitdifferenz zum jeweils nächsten Datenelement aus dem komprimierten Datensatz selektiert werden. Bei dieser Variante der Erfindung findet in der Vorrichtung sowohl Datenkompression als auch Datenanalyse statt. Mit derartigen Vorrichtungen kann vorteilhafterweise ein Fahrzeug ausgestattet werden.

So besteht eine andere Ausprägung der Erfindung in einem Fahrzeug, das eine erfindungsgemäße Vorrichtung aufweist.

Daneben besteht eine weitere Variante der Erfindung in einer Vorrichtung zur Durchführung des Verfahrens, die wenigstens eine Recheneinrichtung aufweist, und die ausgelegt ist den komprimierten Datensatz zu empfangen. Dabei ist die Recheneinrichtung ausgelegt eine Analyse der dezimierten Zeitreihe des Datensatzes durchzuführen, ohne eine Dekompression des Datensatzes vornehmen zu müssen. Diese Vorrichtung würde bevorzugt bei einem Backend-Server zum Einsatz kommen an die die komprimierten Datensätze übertragen werden.

Die Recheneinrichtung kann dabei ausgelegt sein eine Box-Plot-Analyse des komprimierten Datensatzes durchzuführen, indem die dezimierte Zeitreihe nach aufsteigender Größe der auflösungsreduzierten comp(x)-Information sortiert wird und die Kennwerte der Box-Plot-Analyse, insbesondere Minimumwert, Maximalwert, Medianwert, unteres Quartil und oberes Quartil, unter Berücksichtigung der Zeitdifferenz zum jeweils nächsten Datenelement aus dem komprimierten Datensatz selektiert werden.

Schließlich besteht eine weitere Ausprägung der Erfindung in einem Computerprogramm, das ausgelegt ist, bei Abarbeitung in einer Recheneinheit die Schritte des Verfahrens zur Aufbereitung von wenigstens eine Zeitreihe enthaltenden Datensätzen nach einem der erfindungsgemäßen Verfahren durchzuführen.

Ein Ausführungsbeispiel der Erfindung ist in den Zeichnungen dargestellt und wird nachfolgend anhand der Figuren näher erläutert.

Es zeigen:

Fig. 1    das Prinzip der Fahrzeug-zu-Fahrzeug-Kommunikation über Mobilfunk und die Anbindung an das Internet;

Fig. 2    die Struktur eines Datensatzes mit einer Zeitreihe und den einzelnen Datenelementen;

Fig. 3    den klassischen Ablauf eines Vorgangs der Komprimierung eines Datensatzes mit Übertragung zu einem Backend-Server, der über Internet angebunden ist, und anschließender Analyse des Datensatzes nach Dekomprimierung;

Fig. 4    den holistischen Ansatz für den Vorgang der Komprimierung eines Datensatzes, mit dem nach Übertragung zu dem Backend-Server eine anschließende Analyse des Datensatzes möglich wird, ohne der Notwendigkeit der vorherigen Dekomprimierung;

Fig. 5    ein Blockschaltbild der Bordelektronik eines Fahrzeuges;

Fig. 6    die Rohdaten einer Zeitreihe eines beispielhaften Datensatzes und deren Umwandlung in Integerzahlen;

Fig. 7    eine graphische Darstellung der Rohdaten der Zeitreihe des Beispiels von Fig. 6;

Fig. 8    eine Tabelle mit den Ergebnissen für die Berechnung der Rundungsinformation bei dem beispielhaften Datensatz nach dem holistischen Ansatz sowie die Ergebnisse der Rundung;

Fig. 9    den Vorgang der Dezimierung der gerundeten Datenelemente der Zeitreihe des Beispiels von Fig. 6;

Fig. 10    den komprimierten Datensatz nach Durchführung der Dezimierung der gerundeten Datenelemente der Zeitreihe in Tabellenform;

Fig. 11    eine graphische Darstellung der in dem Datensatz verbleibenden Daten der Zeitreihe des Beispiels von Fig. 6 nach Komprimierung;

Fig. 12    eine graphische Darstellung der komprimierten Daten der Zeitreihe des Beispiels von Fig. 6 im Vergleich zu den Rohdaten;

Fig. 13    ein Beispiel einer Datenanalyse in der Art einer Box-Plot-Analyse angewendet auf den Original-Datensatz;

Fig. 14    eine graphische Darstellung der auf die Rohdaten angewendeten Box-Plot-Analyse der Zeitreihe des Beispiels von Fig. 6;

Fig. 15    ein Beispiel einer Datenanalyse in der Art einer Box-Plot-Analyse angewendet auf den komprimierten Datensatz; und

Fig. 16    eine graphische Darstellung der auf die komprimierten Daten angewendeten Boxplot-Analyse der Zeitreihe des Beispiels von Fig. 6.

Die vorliegende Beschreibung veranschaulicht die Prinzipien der erfindungsgemäßen Offenbarung. Es versteht sich somit, dass Fachleute in der Lage sein werden, verschiedene Anordnungen zu konzipieren, die zwar hier nicht explizit beschrieben werden, die aber Prinzipien der erfindungsgemäßen Offenbarung verkörpern und in ihrem Umfang ebenfalls geschützt sein sollen.

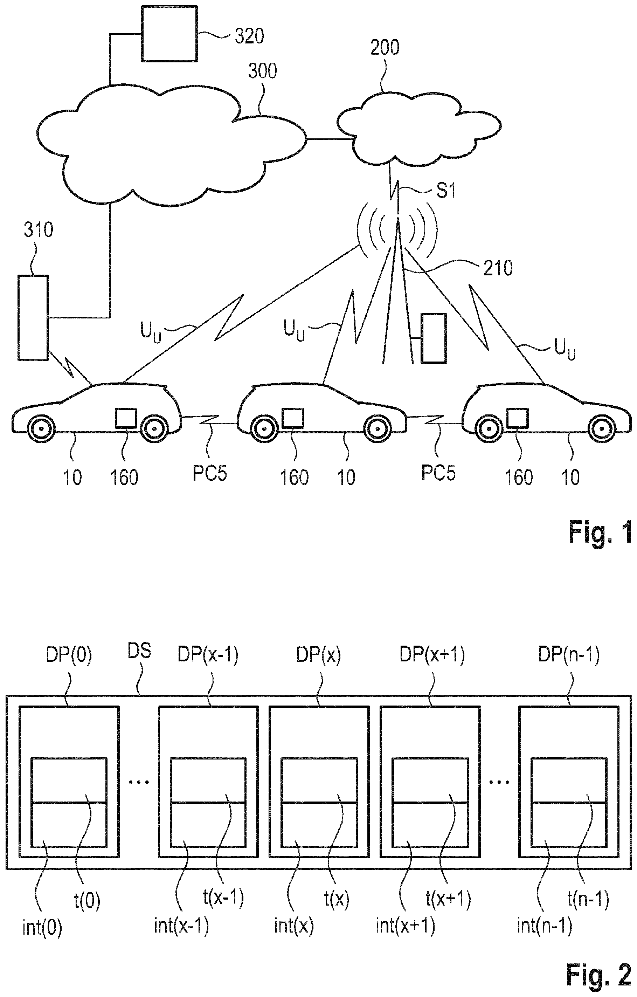

Fig. 1 zeigt eine Systemarchitektur für die Fahrzeugkommunikation mittels Mobilfunk. Die Fahrzeuge sind mit Bezugszahl 10 bezeichnet. Dargestellt sind Personenkraftwagen Pkw. Als Fahrzeug kämen allerdings beliebige andere Fahrzeuge ebenfalls in Betracht. Beispiele von weiteren Fahrzeugen sind: Busse, Nutzfahrzeuge, insbesondere Lastkraftwagen Lkw, Landmaschinen, Baumaschinen, Campingfahrzeuge, Motorräder, Fahrräder, Roller, Rollstühle, Schienenfahrzeuge usw. Der Einsatz der Erfindung bei Fahrzeugen wäre allgemein bei Landfahrzeugen, Schienenfahrzeugen, Wasserfahrzeugen und Luftfahrzeugen einsetzbar. Zudem ist der Einsatz der Erfindung nicht nur auf Fahrzeuge beschränkt. Es kommt der Einsatz der Erfindung allgemein praktisch bei allen Gebieten der Elektrotechnik in Betracht. Als weitere Beispiele werden genannt Maschinen und Anlagen, Kleinelektrogeräte, Geräte der Unterhaltungselektronik, Geräte der weißen Ware, medizinische Geräte, usw. Die Aufzählung ist nicht abschließend gemeint. Die Anbindung von Geräten an die "Cloud" dringt auch in immer weitere Bereiche vor. Ein typisches Stichwort dafür ist der Begriff "Internet of Things" (IoT) durch den ein Trend in der Technik repräsentiert wird, dass immer mehr Geräte in Industrie, Handel und Haushalt durch den Einsatz neuerer Kommunikationstechniken wie 5G an das Internet angebunden werden.

Die Fahrzeuge 10 sind mit einem On-Board-Kommunikationsmodul 160 mit entsprechender Antenneneinheit ausgestattet, so dass das Fahrzeug an den verschiedenen Arten der Fahrzeugkommunikation Fahrzeug-zu-Fahrzeug (V2V) und Fahrzeug-zu-Infrastruktur (V2X) teilnehmen kann. Fig. 1 zeigt, dass das Fahrzeug 10 mit der Mobilfunk-Basisstation 210 eines Mobilfunk-Anbieters kommunizieren kann.

Eine solche Basisstation 210 kann eine eNodeB-Basisstation eines LTE-Mobilfunkanbieters (Long Term Evolution) oder 5G Mobilfunkanbieters (Mobilfunksystem der 5. Generation) sein. Die Basisstation 210 und die entsprechende Ausrüstung ist Teil eines Mobilfunk-Kommunikationsnetzwerks mit einer Vielzahl von Mobilfunkzellen, wobei jede Zelle von einer Basisstation 210 bedient wird.

Die Basisstation 210 ist typischerweise nahe einer Hauptstraße positioniert, auf der die Fahrzeuge 10 fahren. Zusätzlich sind die Fahrzeuge 10 jeweils mit einem On-Board-Kommunikationsmodul 160 ausgestattet. Dieses On-Board-Kommunikationsmodul 160 entspricht einem LTE-Kommunikationsmodul, mit dem das Fahrzeug 10 mobile Daten empfangen kann (Downlink) und solche Daten in Aufwärtsrichtung senden kann (Uplink). V2V- und V2X-Kommunikation wird aber auch durch die 5. Generation von Mobilfunksystemen unterstützt. Dort wird die entsprechende Funkschnittstelle als PC5-Schnittstelle bezeichnet. In Bezug auf das LTE-Mobilfunk-Kommunikationssystem besteht das Evolved UMTS Terrestrial Radio Access-Netzwerk E-UTRAN von LTE aus mehreren eNodeBs, die die E-UTRA-Benutzerebene (PDCP / RLC / MAC / PHY) und die Steuerebene (RRC) bereitstellen. Die eNodeBs sind mittels der sogenannten X2-Schnittstelle miteinander verbunden. Die eNodeBs sind auch über die sogenannte S1-Schnittstelle mit dem EPC (Evolved Packet Core) 200 verbunden.

Aus dieser allgemeinen Architektur zeigt Fig. 1, dass die Basisstation 210 über die S1-Schnittstelle mit dem EPC 200 verbunden ist und der EPC 200 mit dem Internet 300 verbunden ist. Ein Backend-Server 320, an den die Fahrzeuge 10 Nachrichten senden können und von diesem empfangen können, ist ebenfalls mit dem Internet 300 verbunden. Der Backend-Server 320 kann in einem Rechenzentrum des Fahrzeugherstellers oder eines anderen Mobilitätsdienstleisters oder in einem Rechenzentrum einer Behörde, z.B. einer Verkehrsleitstelle untergebracht sein. Schließlich ist auch eine Straßeninfrastrukturstation 310 gezeigt. Diese kann beispielsweise durch eine straßenseitige Einheit, die im Fachjargon oft als "Road Side Unit" RSU 310 bezeichnet wird, veranschaulicht werden. Zur Vereinfachung der Implementierung wird davon ausgegangen, dass allen Komponenten eine Internetadresse zugewiesen wurde, typischerweise in Form einer IPv6-Adresse, so dass die Pakete, die Nachrichten zwischen den Komponenten transportieren, entsprechend geroutet werden können. Die erwähnten verschiedenen Schnittstellen sind standardisiert. Es wird diesbezüglich auf die entsprechenden Spezifikationen des MobilfunkKommunikationssystems verwiesen, die veröffentlicht sind.

Fig. 2 zeigt als Beispiel die Struktur eines Datensatzes, der eine Zeitreihe beinhaltet. Eine Zeitreihe kann einer Messreihe entsprechen. Dabei werden z.B. zeitlich nacheinander Messwerte einer physikalischen Größe, wie Temperatur, Druck, Feuchtigkeit, Geschwindigkeit, Dauer, Drehzahl, Beschleunigung, Länge, Spannung, Widerstand, Lichtstärke, chemische Zusammensetzung, usw. erfasst. Die Zeitreihe besteht im einfachsten Fall aus einer Anzahl von Datenelementen, von denen jedes einen Messwert und den zugehörigen Erfassungszeitpunkt beinhaltet. Oft werden die Erfassungszeitpunkte in zeitlich äquidistanten Abständen aufeinander folgen. Aber auch, wenn die Messwerte nur sporadisch oder periodisch mit variabler Periodendauer erfasst werden, entstehen Zeitreihen. In Fig. 2 ist eine Zeitreihe mit n Datenelementen dargestellt. Es sind die

Datenelemente der Zeitreihe mit DP(0) bis DP(n-1) bezeichnet. Jedes einzelne Datenelement enthält den erfassten Messwert als Integerzahl int(0) bis int(n-1) und den jeweils zugehörigen Zeitstempel t(0) bis t(n-1), der den jeweiligen Erfassungszeitpunkt angibt. Ein Charakteristikum der Zeitreihe besteht darin, dass die Datenelemente nach dem Erfassungszeitpunkt sortiert sind. Typischerweise wird sogar gefordert, dass die Erfassungszeitpunkte streng monoton ansteigend sortiert sein müssen. Dieses Erfordernis kann durch die Relation $t(x) < t(x+1)$ ausgedrückt werden. Nicht immer liefern die Sensoren ihre erfassten Messwerte als Integerzahlen ab. Oft wird es so sein, dass die Sensoren analoge Signale erzeugen, die z.B. über einen Analog-Eingang eines Steuergerätes oder Mikrocontrollers in digitale Signale umgewandelt werden. Dafür wird in der Regel ein Analog/Digital-Wandler eingesetzt, der auch Teil des Mikrocontrollers sein kann. Über Umrechnungstabellen erfolgt dann oft eine Umrechnung in die physikalische Größe.

Physikalische Größen sind aber bekanntermaßen oft mit Vorzeichen behaftet und werden in bestimmten Einheiten angegeben, wobei sich rationale oder reelle Zahlen ergeben können, die im Rechner typischerweise als Gleitkommazahlen gespeichert werden. Dabei gibt es üblicherweise die Darstellung mit "Single" oder "Double Precision", wobei die "Single Precision"-Gleitkommazahl in 32 Bit Speicherplätzen gespeichert wird und die "Double Precision"-Gleitkommazahl in 64 Bit Speicherplätzen gespeichert wird. Es kann immer eine Umrechnung von Gleitkommazahlen in Integerzahlen und umgekehrt erfolgen. Diesbezüglich wird auf die folgende Umrechnungsformel für die Umrechnung von Integerzahl in Gleitkommazahl hingewiesen:

$$fp(x) = int(x) * f + o,$$

wobei fp(x) der Gleitkommazahl entspricht, wobei f einem Multiplikationsfaktor entspricht und o einem Offsetwert.

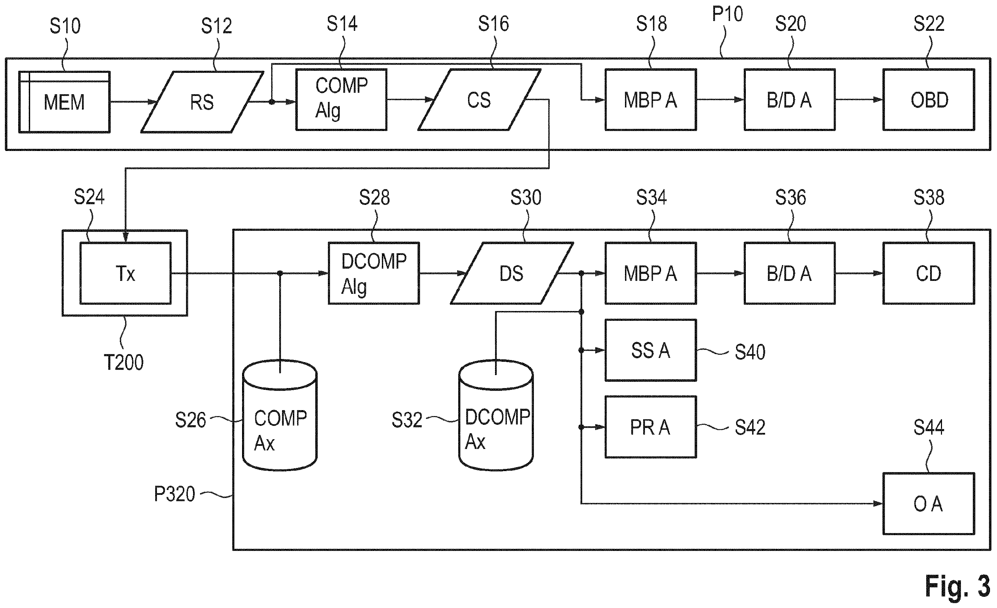

In Fig. 3 ist der klassische Ablauf der Datenerfassung im Fahrzeug und Analyse im Fahrzeug wie auch mit Übertragung und Abspeicherung in der Cloud und Datenanalyse in der Cloud dargestellt. Der obere Teil P10 enthält die Verarbeitungsschritte im Fahrzeug 10. Der mittlere Teil T200 enthält den Schritt der Übertragung der komprimierten Datensätze über Mobilfunk an den Backend-Server 320. Der untere Teil P320 enthält die Verarbeitungsschritte in der Cloud. Zunächst werden die Schritte im Fahrzeug 10 erläutert. Dabei ist die Messwerterfassung nicht gesondert dargestellt. Als erstes wird der Schritt S10 der Speicherung der Daten in einem Speicher eines Steuergerätes dargestellt. Im Schritt S12 erfolgt das Auslesen des Datensatzes aus dem Speicher und das Zuführen des Datensatzes an einen Datenkompressionsalgorithmus. Dieser Algorithmus wird im Schritt S14 durchgeführt. Wie bereits eingangs erwähnt, kann im Schritt S14 ein bekannter ZIP-Komprimierungsalgorithmus eingesetzt werden. Im Schritt S16 wird der komprimierte Datensatz zur Übertragung über Mobilfunk an das entsprechende On-Board-Kommunikationsmodul 160 des Fahrzeuges 10 weitergeleitet.

Nun gibt es Anwendungen, die eine Auswertung der abgespeicherten Datensätze im Fahrzeug 10 erforderlich machen. Als Beispiel wird die Moving Box-Plot-Datenanalyse genannt. Ein Box-Plot soll schnell einen Eindruck darüber vermitteln, in welchem Bereich die Daten liegen und wie sie sich über diesen Bereich verteilen. Deshalb werden alle Werte der sogenannten Fünf-Punkte-Zusammenfassung, also der Median, das untere Quartil (25% Quartil), das obere Quartil (75% Quartil) und die beiden Extremwerte Minimum und Maximum, ermittelt. Diese Werte können sehr gut graphisch in Form eines Zahlenstrahls mit den Einträgen für die fünf Werte der Fünf-Punkte-Zusammenfassung dargestellt werden. Um den Zustand von Verschleißteilen schnell zu erfassen, kann die Box-Plot-Darstellung geeignet sein. Im Schritt S18 findet die Moving Box-Plot-Analyse in Fahrzeug 10 statt.

Eine andere Methode der Datenanalyse, die im Fahrzeug einsetzbar ist, betrifft die Break/Drift-Analyse. Dies entspricht einer Trendanalyse. Hiermit ist es möglich schleichende Abnutzungen zu erkennen. Als Beispiel wird die Abnutzung der Kupplung des Fahrzeuges 10 genannt. Dazu wird z.B. der Vorgang vom Einlegen des 1. Gangs des Getriebes eines Fahrzeuges mit Schaltgetriebe bis zum Losrollen des Fahrzeuges gemessen. Der notwendige Betätigungsweg des Kupplungspedals zum Schließen der Kupplung im Moment des Losrollens verändert sich langsam, wenn die Kupplung immer stärker verschleißt. Im Schritt S20 findet die Break/Drift-Analyse statt. Die Ergebnisse der Datenanalyse werden im Schritt S22 an die On-Board-Diagnoseeinheit weitergeleitet, die dafür sorgt den Fahrer auf den Verschleißzustand des Fahrzeuges 10 aufmerksam zu machen, indem sie z.B. auf einer Anzeigeeinheit eine Warnmeldung ausgibt oder eine Aufforderung zum unverzüglichen Aufsuchen einer Werkstatt.

Es ist nun wichtig herauszustellen, dass die Datenanalysevorgänge im Fahrzeug nach der klassischen Methode mit den unkomprimierten Daten arbeiten. Deshalb ist in Fig. 3 gezeigt, dass die unkomprimierten Rohdaten nach dem Schritt S12 an die Datenanalyseschritte S18 und S22 weitergeleitet werden. Die Datenanalyse im Fahrzeug erfordert die Verarbeitung aller Rohdaten.

Die komprimierten Datensätze werden nach dem Schritt S16 über Mobilfunk an das Rechenzentrum mit Backend-Server 320 übertragen. Dort werden die Datensätze im Schritt S26 in komprimierter Form archiviert. Für eine Datenanalyse ist es aber erforderlich die Datensätze wieder in eine verarbeitbare Form (die Originalform) zurück zu wandeln. Dafür wird ein Dekomprimierungsalgorithmus im Schritt S28 eingesetzt. Der rekonstruierte Datensatz wird im Schritt S30 der nachfolgenden Datenanalyse zur Verfügung gestellt. Er wird optional ebenfalls auch in einem Archivspeicher zur späteren Verwendung abgespeichert, was mit dem Schritt S32 angedeutet wird. Wie schon bereits bei der fahrzeugseitigen Datenanalyse erläutert, kann auch die Moving Box-Plot-Analyse im Schritt S34 und die Break/Drift-Analyse im Schritt S36 im Rechenzentrum durchgeführt werden. Die Ergebnisse werden einer Cloud-Diagnoseeinheit zur Verfügung gestellt, s. Schritt S38. Diese Einheit kann dafür sorgen, dass entsprechende Warnmeldungen über Mobilfunk an das Fahrzeug 10 zurückgesendet werden von dem die Daten stammen. Es sind noch weitere Analysemethode dargestellt, die im Rechenzentrum durchgeführt werden können. Dazu zählen die Ähnlichkeitsanalyse, die im Schritt S40 erfolgt und die Mustererkennung im Schritt S42. Für weitere Einzelheiten zu den verschiedenen Analysemethoden wird auf die Literatur verwiesen. Im Schritt S44 können noch weitere Algorithmen zur Datenanalyse angewendet werden.

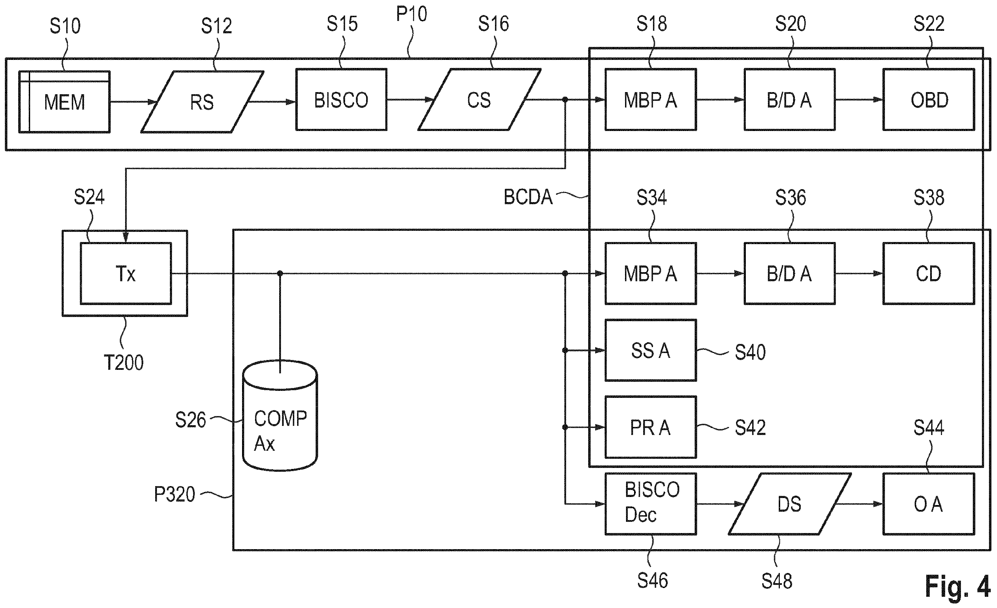

Im Vergleich zur klassischen Form der Datenkompression, Datenarchivierung und Datenanalyse zeigt die Fig. 4 den Ablauf der Datenerfassung im Fahrzeug und Datenanalyse im Fahrzeug, und der Cloud nach der verbesserten Methode gemäß der Erfindung. Gleiche Bezugszeichen bezeichnen die gleiche Schritte und Komponenten wie in Fig. 3. Ein wesentlicher Unterschied besteht in der Art der Komprimierung der Datensätze mit Zeitreihen. Es wird ein Kompressionsalgorithmus eingesetzt, der eine Datenanalyse an den komprimierten Daten erlaubt. Einzelheiten zu dem neuen Kompressionsalgorithmus werden anschließend noch genauer erläutert. Dieser Algorithmus gestattet nun die Datenanalyse mit den komprimierten Daten. In Fig. 4 ist deshalb dargestellt, dass die komprimierten Daten im Schritt S16 an den Analyseschritt S18 weitergeleitet wird. Dadurch müssen wesentlich weniger Daten weitergeleitet werden und auch weniger Daten analysiert werden, wie nachfolgend noch genauer erläutert wird. Dies ist genauso vorteilhaft für die Durchführung der Archivierung und Analyse der Daten in der "Cloud". Fig. 4 zeigt deshalb, dass die Schritte S28 bis S32 entfallen können. Die Datenanalyse erfolgt in den Schritten S34 bis S42 mit den besonders komprimierten Daten. Es kann dabei der Fall auftreten, dass ein Datenanalyseschritt nicht mit den besonders komprimierten Daten durchgeführt werden kann. Dafür ist ein Dekompressionsalgorithmus vorgesehen, der im Schritt S46 durchgeführt wird. Dies ist möglich, weil auch der besondere Kompressionsalgorithmus reversibel ausgelegt wird, so dass eine Rückgewinnung der Daten möglich wird. Dabei kann der Kompressionsalgorithmus so eingestellt werden, dass er verlustlos komprimiert oder verlustbehaftet komprimiert. Wenn er verlustbehaftet eingestellt wird, können die Originaldaten nicht ohne Verluste an Genauigkeit zurückgewonnen werden.

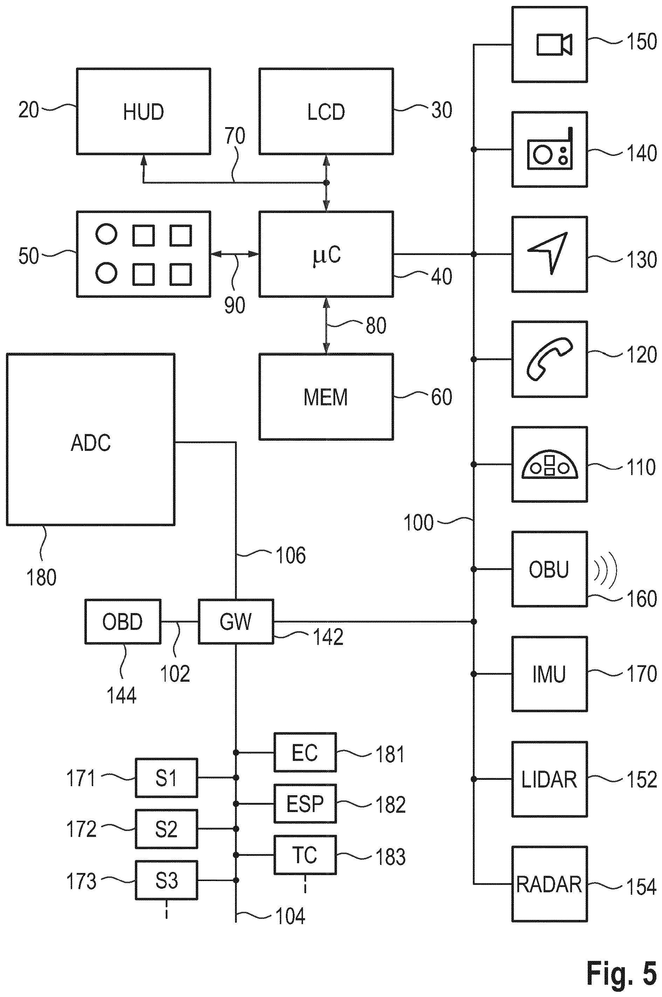

Fig. 5 zeigt schematisch ein Blockschaltbild der Bordelektronik, zu der auch das Infotainmentsystem des Fahrzeuges 10 gehört. Ein Infotainmentsystem bezeichnet bei Fahrzeugen, speziell Pkw, die Zusammenführung von Autoradio, Navigationssystem, Freisprecheinrichtung, Fahrerassistenzsystemen und weiterer Funktionen in einer zentralen Bedieneinheit. Der Begriff Infotainment ist ein Kofferwort, zusammengesetzt aus den Worten Information und Entertainment (Unterhaltung). Zur Bedienung des Infotainmentsystems dient die berührungsempfindliche Anzeigeeinheit 30, eine Recheneinrichtung 40, eine Eingabeeinheit 50 und ein Speicher 60. Die Anzeigeeinheit 30 umfasst sowohl eine Anzeigefläche zum Anzeigen veränderlicher grafischer Informationen als auch eine über der Anzeigefläche angeordnete Bedienoberfläche (berührungssensitive Schicht) zum Eingeben von Befehlen durch einen Benutzer. Sie kann als LCD-Touchscreen-Display ausgebildet sein.

Der Bildschirm 30 kann insbesondere von einem Fahrer des Fahrzeugs 10, aber auch von einem Beifahrer des Fahrzeugs 10 gut eingesehen und bedient werden. Unterhalb des Bildschirms 30 können zudem mechanische Bedienelemente, beispielsweise Tasten, Drehregler oder Kombinationen hiervon, wie beispielsweise Drückdrehregler, in einer Eingabeeinheit 50 angeordnet sein. Typischerweise ist auch eine Lenkradbedienung von Teilen des Infotainmentsystems möglich. Diese Einheit ist nicht separat dargestellt, sondern wird als Teil der Eingabeeinheit 50 betrachtet.

Die Anzeigeeinheit 30 ist über eine Datenleitung 70 mit der Recheneinrichtung 40 verbunden. Die Datenleitung kann nach dem LVDS-Standard ausgelegt sein, entsprechend Low Voltage Differential Signalling. Über die Datenleitung 70 empfängt die Anzeigeeinheit 30 Steuerdaten zum Ansteuern der Anzeigefläche des Touchscreens 30 von der Recheneinrichtung 40. Über die Datenleitung 70 werden auch Steuerdaten der eingegebenen Befehle von dem Touchscreen 30 zu der Recheneinrichtung 40 übertragen. Die Eingabeeinheit 50 ist über die Datenleitung 90 mit der Recheneinheit 40 verbunden.

Die Speichereinrichtung 60 ist über eine Datenleitung 80 mit der Recheneinrichtung 40 verbunden. In dem Speicher 60 ist ein Piktogrammverzeichnis und/oder Symbolverzeichnis hinterlegt mit den Piktogrammen und/oder Symbolen für die möglichen Einblendungen von Zusatzinformationen.

Zusätzlich ist eine Projektionseinheit 20 an die Recheneinrichtung 40 über die Datenleitung 70 angeschlossen, in Form eines Head-Up-Displays ausgeführt sein kann und zur Einblendung von "augmented reality"-Information in das Sichtfeld des Fahrers dient.

Die weiteren Teile des Infotainmentsystems Kamera 150, Radio 140, Navigationsgerät 130, Telefon 120 und Kombiinstrument 110 sind über den Datenbus 100 mit der Vorrichtung zur Bedienung des Infotainmentsystems verbunden. Als Datenbus 100 kommt die Highspeed-Variante des CAN-Bus nach ISO Standard 11898-2 in Betracht. Alternativ käme z.B. auch der Einsatz eines auf Ethernet-Technologie beruhenden Bussystems wie BroadR-Reach in Frage. Auch Bussysteme, bei denen die Datenübertragung über Lichtwellenleiter geschieht, sind einsetzbar. Als Beispiele werden genannt der MOST Bus (Media Oriented System Transport) oder der D2B Bus (Domestic Digital Bus). An den Datenbus 100 ist auch eine Fahrzeug-Messeinheit 170 angeschlossen. Diese Fahrzeug-Messeinheit 170 dient der Erfassung der Bewegung des Fahrzeuges, insbesondere der Erfassung der Beschleunigungen des Fahrzeuges. Sie kann als konventionelle IMU-Einheit, entsprechend Inertial Measurement Unit, ausgebildet sein. In einer IMU-Unit finden sich typischerweise Beschleunigungssensoren und Drehratensensoren wie ein Laser-Gyroskop oder ein Magnetometer-Gyroskop. Die Fahrzeug-Messeinheit 170 kann als Teil der Odometrie des Fahrzeuges 10 angesehen werden. Dazu gehören aber auch die Raddrehzahlsensoren.

Hier wird noch erwähnt, dass die Kamera 150 als konventionelle Videokamera ausgelegt sein kann. In diesem Fall nimmt sie 25 Vollbilder/s auf, was bei dem Interlace-Aufnahmemodus 50 Halbbildern/s entspricht. Alternativ kann eine Spezialkamera eingesetzt werden, die mehr Bilder/s aufnimmt, um die Genauigkeit der Objekterkennung bei sich schneller bewegenden Objekten zu erhöhen, oder die Licht in einem anderen als dem sichtbaren Spektrum aufnimmt. Es können mehrere Kameras zur Umfeldbeobachtung eingesetzt werden. Daneben werden auch RADAR- oder LIDAR-Sensoren 152 und 154 ergänzend oder alternativ eingesetzt, um die Umfeldbeobachtung durchzuführen oder zu erweitern. Für die drahtlose Kommunikation nach innen und außen ist das Fahrzeug 10 mit dem Kommunikationsmodul 160 ausgestattet, wie bereits erwähnt.

Mit der Bezugszahl 181 ist ein Motorsteuergerät bezeichnet. Die Bezugszahl 182 entspricht einem ESP-Steuergerät und die Bezugszahl 183 bezeichnet ein Getriebe-Steuergerät. Weitere Steuergeräte, wie ein zusätzliches Fahrdynamik-Steuergerät (für Fahrzeuge mit elektrisch verstellbaren Dämpfern), Airbag-Steuergerät usw., können im Fahrzeug vorhanden sein. Die Vernetzung solcher Steuergeräte, die alle der Kategorie des Antriebsstrangs zugerechnet werden, geschieht typischerweise mit dem CAN-Bussystem (Controller Area Network) 104, welches als ISO Norm standardisiert ist, meist als ISO 11898-1. Für verschiedene Sensoren 171 bis 173 im Kraftfahrzeug, die nicht mehr nur an einzelne Steuergeräte angeschlossen werden sollen, ist es ebenfalls vorgesehen, dass sie an das Bussystem 104 angeschlossen werden und deren Sensordaten über den Bus zu den einzelnen Steuergeräten übertragen werden. Beispiele von Sensoren im Kraftfahrzeug sind Raddrehzahlsensoren, Lenkwinkelsensoren, Beschleunigungssensoren, Drehratensensoren, Reifendrucksensoren, Abstandssensoren, Klopfsensoren, Luftgütesensoren usw. Insbesondere die Raddrehzahlsensoren und die Lenkwinkelsensoren sind der Odometrie des Fahrzeuges zuzurechnen. Die Beschleunigungssensoren und Drehratensensoren können auch direkt an die Fahrzeug-Messeinheit 170 angeschlossen sein.

Die Bezugszahl 144 bezeichnet eine On-Board-Diagnoseschnittstelle (OBD). Diese dient zum Anschluss eines Diagnosegerätes bei einem Aufenthalt in der Werkstatt. Darüber können die im Fahrzeug abgespeicherten Fehlerdaten ausgelesen werden. Die On-Board-Diagnoseschnittstelle 144 ist über den Kommunikationsbus 102 mit dem Gateway 142 verbunden. Das Gateway 142 dient dazu, einen Austausch von Informationen aus den verschiedenen Kommunikationszweigen zu ermöglichen. Es führt dazu eine Formatwandlung durch, um z.B. eine Nachricht, die es im Format des Bussystems 100 empfängt, in das Format des Bussystems 104 umzuwandeln. Entsprechendes findet auch bei den Weiterleitungen zwischen den anderen Bussystemen der Bordelektronik statt.

Mit der Bezugszahl 180 ist ein weiteres Steuergerät bezeichnet, das für eine automatisierte Fahrfunktion bzw. für ein oder mehrere Fahrerassistenzsysteme zuständig ist. Es können damit verschiedene Fahrstufen bzgl. des automatisierten Fahrens realisiert werden. Es muss eine entsprechend leistungsfähige Recheneinheit in dem Steuergerät 180 vorgesehen werden, um die jeweils gewünschte Fahrstufe implementieren zu können.

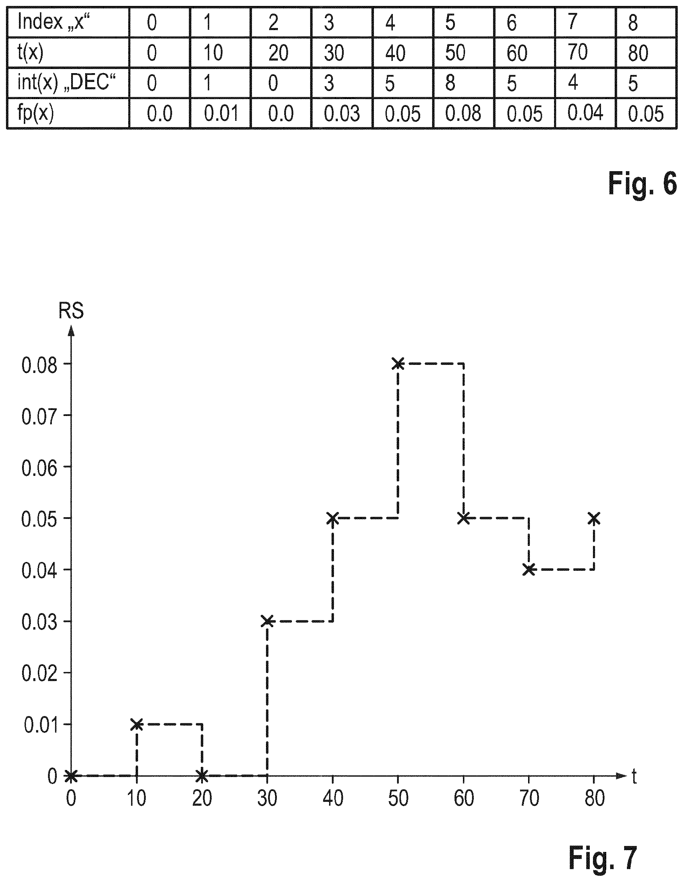

Im Folgenden wird der Fall betrachtet, dass der Sensor 171, der an den CAN-Bus 104 angeschlossen ist Messwerte erfasst und zum Gateway 142 überträgt. Im Speicher des Gateway 142 werden die gemessenen Werte archiviert. Ein Beispiel einer solchen Messreihe ist in der Fig. 6 in Tabellenform gezeigt. Allerdings handelt es sich um eine fiktive Messreihe mit der das Prinzip des Kompressionsverfahrens erläutert wird. In der obersten Zeile ist der Index des jeweiligen Messwertes eingetragen. Die Messungen erfolgten in äquidistanten Zeitabständen von 10 ms. Die zweite Zeile enthält die Zeitangabe t(x) wann der jeweilige Messwert erfasst wurde. Die Messreihe kann in Abhängigkeit eines bestimmten Ereignisses gestartet werden. Die Messwerterfassung erfolgte im Bereich von 0 bis 80 ms nach Eintreten des Ereignisses. In der vierten Zeile finden sich die Messwerte fp(x) in Form von Dezimalzahlen mit zwei Nachkommastellen. Diese Zahlen werden von dem Sensor 171 als Integerzahlen über den CAN-Bus 104 zum Gateway 142 übertragen. Die Messwerte liegen in dem Zahlenbereich von 0,0 bis 0,08.

Die Fig. 7 zeigt die Messwerte der Tabelle in Fig. 6 in graphischer Darstellung. Dabei sind entlang der Abszisse der Graphik die jeweiligen Messzeitpunkte aufgetragen im Bereich von 0 bis 80 ms. Entlang der Ordinate sind die Messwerte fp(x) aufgetragen im Bereich von 0 bis 0,08. Die Messpunkte sind mit einem Kreuz-Symbol illustriert. Die gestrichelte Verbindung der Messpunkte entspricht einer Treppenfunktion.

Der neuartige Kompressionsalgorithmus, der eine Datenkompression bewirkt, wird von einer Recheneinheit im Gateway 142 abgearbeitet. Dieser Algorithmus beruht auf Rundung der Messwerte durch Bitverschiebung. Diese Operation ist auch Namensgeber des Algorithmus, der als BISCO-Algorithmus bezeichnet wird, entsprechend "BInary Shift COmpression".

Zuvor werden die Messwerte bei Bedarf noch in Integer-Zahlen umgewandelt. Bei Vorzeichen-behafteten Zahlen können die Messwerte in das Format von "signed" Integer-Zahlen umgewandelt werden. Bei nicht mit Vorzeichen behafteten Messwerten können die Zahlen in "unsigned" Integer-Zahlen umgewandelt. Auch diese Umwandlung kann im Gateway 142 erfolgen.

Viele Sensoren stellen die Messwerte bereits im Integer-Zahlenformat zur Verfügung, so dass bei solchen Sensoren der Schritt der Umwandlung in Integer-Zahlen entfallen kann. Der Kompressionsalgorithmus arbeitet mit den Integer-Zahlen.

Der Ablauf des BISCO-Algorithmus wird hier in C++-Programmiersprachen-Syntax angegeben und besteht aus 6 Schritten.

1. set index x = 0
2. calculate round information "rnd(x)": rnd(x) = int(x)>>(nbit-1) & 0x1
3. calculate compressed value "comp(x)" with lower accuracy - "nbit" right shift:

$$\text{comp}(x) = (\text{int}(x) >> \text{nbit}) + \text{rnd}(x)$$

4. if "comp(x)" is EQUAL "last" AND x > 0: go to 6
5. remember index "x" for transmission. Set "last" to "comp(x)".
6. Increase x = x+1, go to step 2 and continue with next time "t(x+1)" and value "int(x+1)"

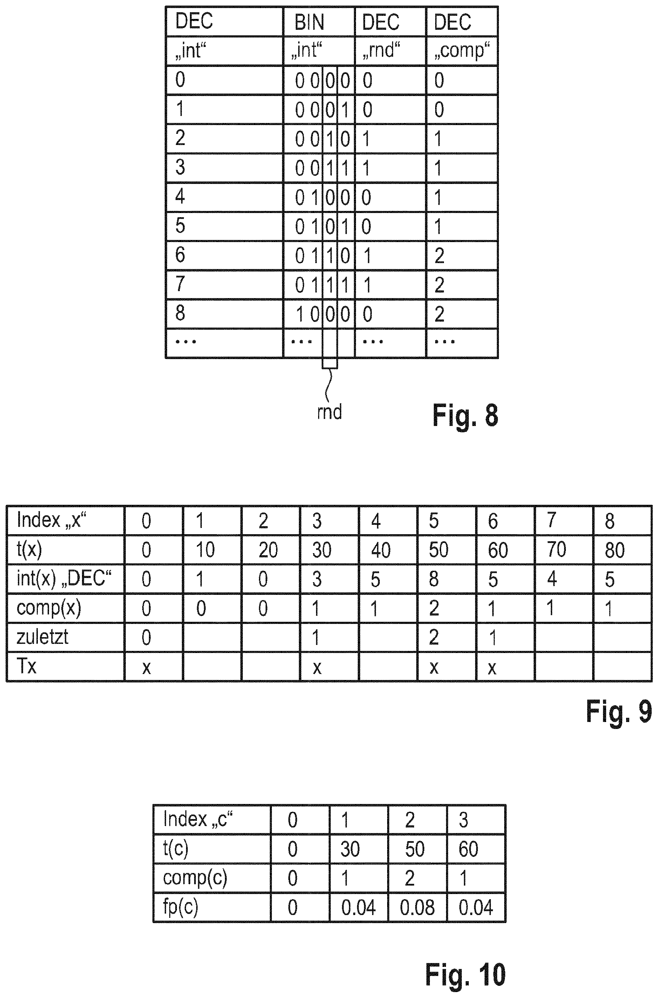

Im 1. Schritt wird der Messwert-Index x auf den Anfangswert 0 gesetzt. Im 2. Schritt wird die Rundungsinformation rnd(x) errechnet, die an der Bitstelle nbit-1 der Integer-Zahlen int(x) eingefügt werden soll. Diese Rundungsinformation rnd(x) wird errechnet, indem die Integer-Zahl int(x) um die Anzahl nbit-1 Stellen nach rechts verschoben wird und mit dem Binärwert "1" logisch UND-verknüpft wird. Dabei kann durch Wahl des Parameters nbit angegeben werden wie stark gerundet werden soll. Dies ist gleichbedeutend mit der Wahl des Kompressionsgrades für den Kompressionsalgorithmus. Wird nbit = 0 gewählt, bedeutet dies, dass eine verlustfreie Kompression durchgeführt werden soll. Im dritten Schritt wird der komprimierte Wert berechnet. Dabei wird die Integer-Zahl int(x) um nbit nach rechts verschoben und zu der berechneten Rundungsinformation rnd(x) hinzuaddiert. Der Ablauf der Rundungsoperation und die sich ergebenden gerundeten Werte comp(x) sind in der Tabelle der Fig. 8 dargestellt. In dem in Fig. 8 gezeigten Fall wurde nbit = 2 gesetzt. Es wird im 2. Schritt die Integer-Zahl um eine Stelle (nbit-1 = 1) nach rechts verschoben. Diese Stelle ist in der Tabelle der Fig. 8 umrandet und mit rnd bezeichnet. Durch die UND-Verknüpfung ergeben sich die Rundungsinformationswerte rnd(x), wie in der dritten Spalte der Tabelle von Fig. 8 angegeben. Im 3. Schritt wird der Eintrag der um zwei Bitstellen nach rechts verschobenen Integer-Zahl mit der Rundungsinformation rnd(x) addiert. Die Ergebnisse comp(x) sind in der vierten Spalte der Tabelle dezimal angegeben. Im 4. Schritt erfolgt ein Schritt der Dezimierung der Elemente der Messreihe. Dabei werden Datenelemente, deren gerundetes Datum comp(x) sich nicht vom gerundeten Datum comp(x-1) des direkten zeitlichen Vorgängers unterscheidet, entfernt. Stützwerte sind dabei die Werte Dezimal 0, Dezimal 1 und Dezimal 2. Das sind also die Werte in der Tabelle, bei denen sich die gerundeten Werte comp(x) von den vorhergehenden Werten comp(x-1) unterscheiden.

Der Fortgang des Kompressionsalgorithmus in den Schritten 4 bis 6 ist in der weiteren Tabelle von Fig. 9 dargestellt. In der fünften Zeile "last" sind die Stützwerte angegeben. Nur diese Werte werden im komprimierten Datensatz behalten und entweder im Fahrzeug 10 gespeichert oder weitergeleitet zum On-Board-Kommunikationsmodul 160 und von dort zu dem Backend-Server 320 übertragen. In der sechsten Zeile "transmit" ist mit x markiert welche Datenelemente der Zeitreihe behalten und übertragen werden. Die komprimierte Zeitreihe ist in der Tabelle der Fig. 10 gezeigt. Der fertig komprimierte Datensatz für die komprimierte Zeitreihe besteht allerdings nur aus den Zeilen t(c) und comp(c). In der Zeile fp(c) sind zum Vergleich noch die Gleitkommazahlen eingetragen, die sich aus den gerundeten comp(x)-Werten der Datenelemente ergeben. Die Berechnung der Gleitkommazahlen fp(c) aus comp(c) erfolgt mit dem Faktor fc = 2^nbit*f, welcher die Verschiebung um n Bit korrigiert. Dabei ergibt sich der Faktor fc aus dem oben erwähnten Faktor f und der gewählten nbit-Angabe. Bei der Übertragung des komprimierten Datensatzes können optional auch noch Metadaten übertragen werden, wenn diese sich für den Anwendungsfall nicht schon aus anderen Informationen ergeben. Es könnten die Informationen für den Faktor f, bzw. fc, und den Offsetwert o sowie die nbit-Angabe für die Umwandlung der Integer-Zahlen in Gleitkommazahlen optional mit übertragen werden sowie ggfs. noch die physikalische Einheit, in der der Sensor 171 die Werte erfasst hatte.

Die Kompression ergibt sich somit durch den Rundungsschritt in Verbindung mit dem Schritt der Dezimierung. Übrig bleiben nur noch die Stützwerte in der Zeitreihe.

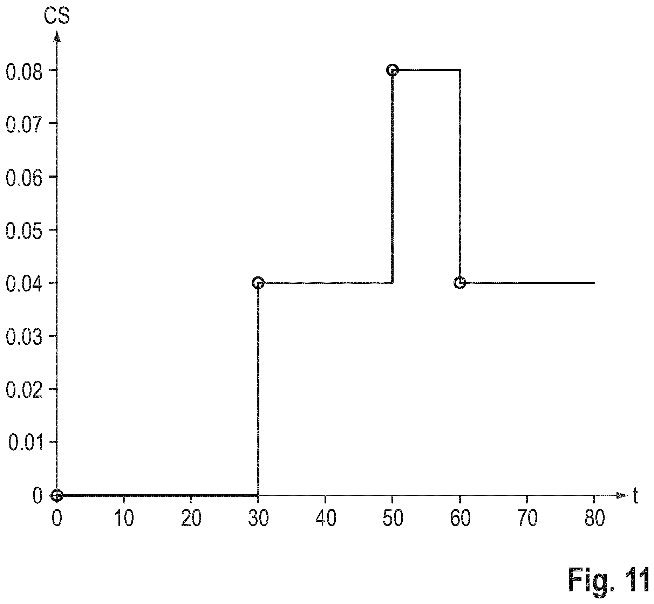

Eine graphische Darstellung der in der komprimierten Zeitreihe verbleibenden Werte zeigt die Fig. 11. Die verbleibenden Stützwerte sind mit Kreis-Symbolen dargestellt.

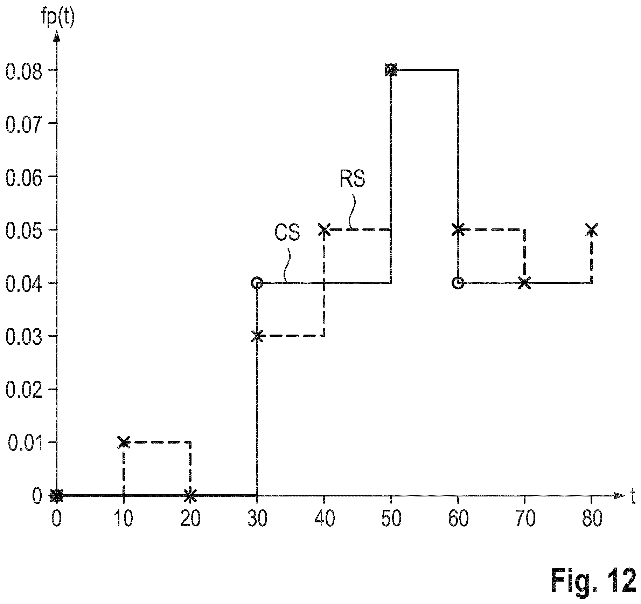

Eine vergleichende Darstellung mit den Original-Messwerten und den Stützwerten der komprimierten Darstellung ist in Fig. 12 gezeigt. Die Original-Messwerte, in Fig. 12 "Raw Signal" (RS) genannt, sind mit Kreuz-Symbolen dargestellt. Es ist daran deutlich erkennbar, dass die verbleibenden Stützwerte, in Fig. 12 "Compressed Signal" (CS) genannt, nicht in jedem Fall Original-Messwerten entsprechen, sondern gerundete Werte darstellen, die zwischen Original-Messwerten liegen können.

Als nächstes wird erläutert, wie es mit den so komprimierten Datensätzen möglich ist eine Datenanalyse durchzuführen ohne zuvor eine Dekompression durchführen zu müssen. Dafür wird das Beispiel der Box-Plot-Analyse gewählt.

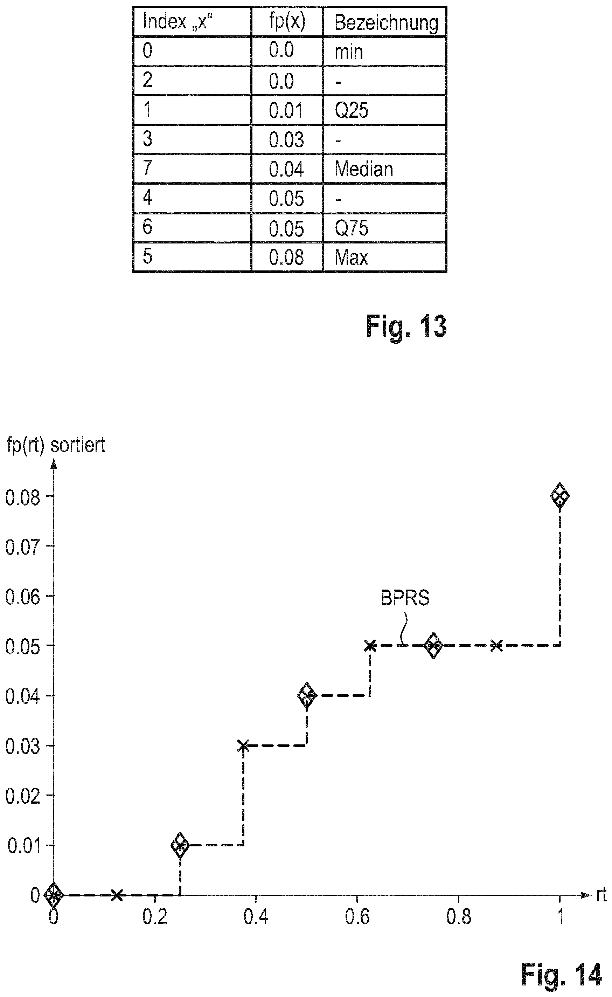

Zunächst wird das Ergebnis der Box-Plot-Analyse am Beispiel der Original-Messwerte in der Fig. 13 gezeigt. Wie zuvor beschrieben, zielt die Box-Plot-Analyse darauf ab, die beiden Extremwerte der Messreihe anzugeben, den Median-Wert und die beiden Quartil-Werte Q25 und Q75. Alle fünf Werte sind in der Tabelle von Fig. 13 in der 3. Spalte beschrieben.

In der Fig. 14 sind die fünf Ergebniswerte der Box-Plot-Analyse [Box Plot Raw Signal (BPRS)] in graphischer Darstellung gezeigt. Die charakteristischen Box-Plot-Analyse-Werte sind in Fig. 14 mit Rauten-Symbolen gekennzeichnet.

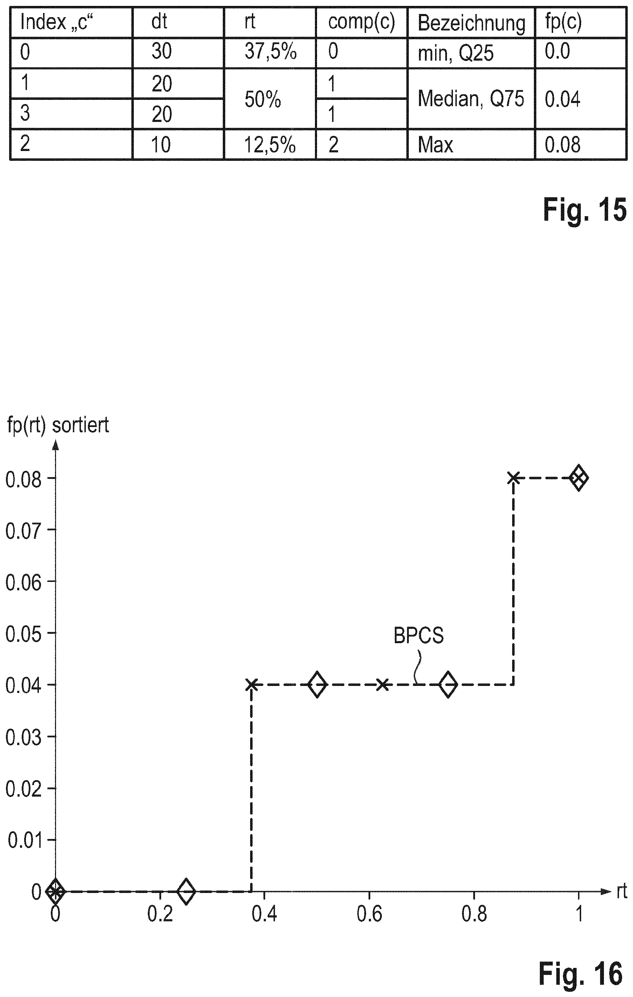

Die Fig. 15 zeigt in tabellarischer Form, wie die Box-Plot-Analyse mit dem komprimierten Datensatz funktioniert.

Wichtig ist dabei, dass die Differenzzeit dt zum nächsten Datenelement, die ja aus den mitnotierten Messzeitpunkten in dem komprimierten Datensatz leicht errechnet werden kann, berücksichtigt wird. Bei der Box-Plot-Analyse werden also zunächst mal die Differenzzeiten ausgerechnet und bei den Datenelementen mit eingetragen. Sodann erfolgt ein Schritt der Sortierung der Datenelemente nach aufsteigender Größe der komprimierten Integer-Zahlen comp(c). In der ersten Reihe der so sortierten Zeitreihe steht dann der Minimum-Wert. Es wird danach analysiert welcher Wert (das untere Quartil Q25) bei 25% der relativen Zeit zu finden ist. Die gesamte Zeit, die durch die Messwerte abgedeckt wird, entspricht 80 ms. Dies folgt aus Addition der Werte der Spalte dt. Der Q25-Wert findet sich deshalb bei 20 ms bereits im ersten Intervall zwischen den Stützwerten "0" und "1", denn laut Tabelle in Fig. 14 liegt der Wert "0" für eine Zeitdauer von 30 ms an. Deshalb ist der Q25-Wert ebenfalls für den Wert comp(c) = 0 eingetragen. Der Median-Wert ist der Wert, der genau "in der zeitlichen Mitte" der relativen Zeit, also bei der relativen Zeit 0.5, positioniert ist, wenn man die Messwerte der Größe nach sortiert. Daher entspricht der Median dem Wert "1", s. Tabelle in Fig. 15. Der Q75-Wert wird im Prinzip genauso ermittelt wie der Q25-Wert. Er entspricht deshalb im Beispiel auch dem Wert "1", weil er bei 75% der repräsentierten Gesamtzeit (entsprechend 60 ms) positioniert ist, was noch bei dem Wert "1" liegt, denn der Höchstwert "2" wird erst nach 70 ms erreicht, dies entspricht aber einer relativen Zeit von 87,5% der Gesamtzeit von 80 ms. Der 75%-Wert liegt daher noch bei der "1".

Die Fig. 16 zeigt noch die ermittelten Ergebnisse der Box-Plot-Analyse mit dem komprimierten Datensatz [Box Plot Compressed Signal (BPCS)]. Der Sortier- und Suchaufwand ist für die Box-Plot-Analyse mit den komprimierten Datensätzen entsprechend verringert. Für reale Messreihen können leicht Tausende von Messwerten aufgezeichnet werden, so dass der Aufwand für die Analyse der Rohdatensätze beträchtlich ansteigt und sich deshalb der Sortier- und Suchaufwand bei den komprimierten Datensätzen erheblich verringert.

Es ist auch möglich andere Analysemethoden mit den komprimierten Datensätzen durchzuführen. Als Beispiel werden genannt, die Ähnlichkeitsanalyse, die Mustererkennung und die Trendanalyse. Dazu gehören aber auch einfache Algorithmen, die die Informationen für eine graphische Darstellung aufbereiten, wie Balkendiagramm, Tortendiagramm, usw. Als weiteres Beispiel wird die Histogramm-Darstellung genannt, bei der z.B. die relativen Dauern in den verschiedenen Klassen betrachtet werden.

Ist eine Analysemethode mit den komprimierten Integer-Zahlen nicht möglich, so kann erst noch eine Umwandlung in Gleitkommazahlen durchgeführt werden nach der Formel fp(c) = comp(c) * fc + o, wie oben beschrieben. Erfordert eine Analysemethode zeitlich äquidistante Werte und/oder Werte aller notwendigen Signale zu jedem Zeitpunkt t, so kann diese Darstellungsform aus der komprimierten Darstellung erzeugt werden (Dekompression). Dazu wird bevorzugt für jedes Signal der zum gewünschten Zeitpunkt gültige letzte Wert bestimmt. Prinzipiell könnten diese Werte auch durch andere Algorithmen (z. B. Interpolation, z.B. mit linearer Regression oder nicht-linearer Regression z.B. basierend auf "Cubic Spline"-Funktionen, etc.) berechnet werden.

Die Datenanalyse kann ebenfalls von dem Gateway 142 durchgeführt werden. Wenn eine kritische Abweichung von einem Sollwert erkannt wird, kann das Gateway 142 eine Nachricht zu der Recheneinheit 40 senden, die dann eine Warnmeldung erzeugt, die dem Fahrer über die Anzeigeeinheit 30 und/oder 20 angezeigt wird. Die Datenanalyse kann aber ebenfalls bei dem Backend-Server 320 durchgeführt werden, zu dem die komprimierten Datensätze übertragen wurden.

Alle hierin erwähnten Beispiele wie auch bedingte Formulierungen sind ohne Einschränkung auf solche speziell angeführten Beispiele zu verstehen. So wird es zum Beispiel von Fachleuten anerkannt, dass das hier dargestellte Blockdiagramm eine konzeptionelle Ansicht einer beispielhaften Schaltungsanordnung darstellt. In ähnlicher Weise ist zu erkennen, dass ein dargestelltes Flussdiagramm, Zustandsübergangsdiagramm, Pseudocode und dergleichen verschiedene Varianten zur Darstellung von Prozessen darstellen, die im Wesentlichen in computerlesbaren Medien gespeichert und somit von einem Computer oder Prozessor ausgeführt werden können.

Es sollte verstanden werden, dass das vorgeschlagene Verfahren und die zugehörigen Vorrichtungen in verschiedenen Formen von Hardware, Software, Firmware, Spezialprozessoren oder einer Kombination davon implementiert werden können. Spezialprozessoren können anwendungsspezifische integrierte Schaltungen (ASICs), Reduced Instruction Set Computer (RISC) und/oder Field Programmable Gate Arrays (FPGAs) umfassen. Vorzugsweise wird das vorgeschlagene Verfahren und die Vorrichtung als eine Kombination von Hardware und Software implementiert. Die Software wird vorzugsweise als ein Anwendungsprogramm auf einer Programmspeichervorrichtung installiert. Typischerweise handelt es sich um eine Maschine auf Basis einer Computerplattform, die Hardware aufweist, wie beispielsweise eine oder mehrere Zentraleinheiten (CPU), einen Direktzugriffsspeicher (RAM) und eine oder mehrere Eingabe/Ausgabe (I/O) Schnittstelle(n). Auf der Computerplattform wird typischerweise außerdem ein Betriebssystem installiert. Die verschiedenen Prozesse und Funktionen, die hier beschrieben wurden, können Teil des Anwendungsprogramms sein oder ein Teil, der über das Betriebssystem ausgeführt wird.

Die Offenbarung ist nicht auf die hier beschriebenen Ausführungsbeispiele beschränkt. Es gibt Raum für verschiedene Anpassungen und Modifikationen, die der Fachmann aufgrund seines Fachwissens als auch zu der Offenbarung zugehörend in Betracht ziehen würde. Die Erfindung ist durch die Ansprüche definiert.

**Bezugszeichenliste**

| | |
|---|---|
| 10 | Fahrzeug |
| 20 | Head-Up Display |
| 30 | berührungsempfindliche Anzeigeeinheit |
| 40 | Recheneinheit |
| 50 | Eingabeeinheit |
| 60 | Speichereinheit |
| 70 | Datenleitung zur Anzeigeeinheit |
| 80 | Datenleitung zur Speichereinheit |
| 90 | Datenleitung zur Eingabeeinheit |
| 100 | Datenbus |
| 102 | Diagnosebus |
| 104 | CAN-Bus |
| 106 | Ethernet-Bus |
| 110 | Kombiinstrument |
| 120 | Telefon |
| 130 | Navigationsgerät |
| 140 | Radio |
| 142 | Gateway |
| 144 | On-Board-Diagnoseschnittstelle |
| 150 | Kamera |
| 160 | Kommunikationsmodul |
| 170 | Fahrzeug-Messeinheit |
| 171 | Sensor 1 |
| 172 | Sensor 2 |
| 173 | Sensor 3 |
| 180 | Steuereinheit für automatische Fahrfunktion |
| 181 | Motorsteuergerät |
| 182 | ESP-Steuergerät |
| 183 | Getriebesteuergerät |
| 200 | Evolved Packet Core |
| 300 | Internet |
| 310 | Road Side Unit |
| 320 | Backend-Server |
| BCDA | Datenanalyse mit den BISCO-komprimierten Datensätzen |
| DP(0) - DP(n-1) | Datenelement |
| DS | Datensatz |
| int(0) - int(n-1) | Integer-Zahlen |
| P10 | Prozessschritte im Fahrzeug |
| P320 | Prozessschritte beim Backend-Server |
| S10 | Speichern des Rohdatensatzes |
| S12 | Lesen des Rohdatensatzes |
| S14 | Durchführen des Kompressionsalgorithmus |
| S15 | Durchführen des BISCO-Algorithmus |
| S16 | Weiterleiten komprimierten Datensatzes |
| S18 | Durchführen der Box-Plot-Analyse mit den Rohdaten |
| S20 | Durchführen der Break/Drift-Analyse mit den Rohdaten |
| S22 | Ausgeben von Warnmeldungen |
| S24 | Übertragen des komprimierten Datensatzes an die Cloud |
| S26 | Archivieren des komprimierten Datensatzes |
| S28 | Durchführen des Dekompressionsalgorithmus |
| S30 | Weiterleiten des rekonstruierten Datensatzes |
| S32 | Archivieren des rekonstruierten Datensatzes |
| S34 | Durchführen der Box-Plot-Analyse |
| S36 | Durchführen der Break/Drift-Analyse |

| | |
|---|---|
| S38 | Erzeugen und Übertragen von Warnmeldungen an das Fahrzeug |
| S40 | Durchführen der Ähnlichkeits-Analyse |
| S42 | Durchführen der Mustererkennung |
| S44 | Durchführen anderer Analyse-Methoden mit rekonstruierten Daten |
| S46 | Durchführen des Dekompressionsalgorithmus |
| S48 | Weiterleiten des rekonstruierten Datensatzes an andere Analysemethoden |
| t(0) - t(n-1) | Zeitpunkte |
| T200 | Übertragung der Datensätze über Mobilfunk |

**Patentansprüche**

1. Verfahren zur Aufbereitung von wenigstens eine Zeitreihe enthaltenden Datensätzen durch eine Recheneinheit, wobei die Zeitreihe die zu bestimmten Zeitpunkten erfassten Daten (int(0) - int(n-1)) und den jeweiligen Zeitpunkt (t(0) - t(n-1)) der Datenerfassung als Datenelemente (DP(0) - DP(n-1)) enthält, wobei ein Schritt einer Rundung der erfassten Daten (int(0) - int(n-1)) mit einer nachfolgenden Dezimierung der in der wenigstens einen Zeitreihe enthaltenen Datenelemente (DP(0) - DP(n-1)) des Datensatzes (DS) durchgeführt wird und die dezimierte Zeitreihe des Datensatzes (DS) in der Recheneinheit abgespeichert und/oder an eine externe Recheneinrichtung übertragen wird, und wobei der Schritt der Dezimierung es beinhaltet, dass die Änderung der gerundeten Daten der Datenelemente (DP(0) - DP(n-1)) der Zeitreihe untersucht wird, und diejenigen Datenelemente (DP(x)) entfernt werden, bei denen die gerundeten Werte gleich den gerundeten Werten des jeweils zeitlich direkt benachbarten Vorgängerdatenelements (DP(x-1)) sind.

2. Verfahren nach Anspruch 1, wobei die Zeitreihe einer Messwertreihe entspricht, wobei die Messwerte als Integer-Zahlen erfasst werden oder als Gleitkommazahlen erfasst werden und in Integer-Zahlen (int(0) - int(n-1)) umgewandelt werden.

3. Verfahren nach Anspruch 2, wobei für die Umwandlung in Integer-Zahlen (int(0) - int(n-1)) von den Gleitkommazahlen der Datenelemente (DP(0) - DP(n-1)) der Zeitreihe ein Offset "o" subtrahiert wird und das Ergebnis der Subtraktion durch einen Faktor "f" geteilt wird.

4. Verfahren nach Anspruch 3, wobei zur Vorbereitung für die Dezimierung der Datenelemente (DP(0) - DP(n-1)) der Zeitreihe ein Algorithmus durchgeführt wird, der auf einer Rundung der Integer-Zahlen (int(0) - int(n-1)) beruht.

5. Verfahren nach Anspruch 4, wobei die Rundungsoperation nach folgender Vorschrift vorbereitet wird:

$$rnd(x) = AND(BSR(int(x), nbit-1), 1)$$

wobei rnd(x) einer Rundungsinformation der Integer-Zahl entspricht, die für eine nachfolgende Rundungsoperation ausgewählt wird, wobei x einem Datenelementindex entspricht, wobei int(x) der Integer-Zahl entspricht, wobei nbit-1 angibt welche Bitstelle der Integer-Zahl für die Berechnung der Rundungsinformation rnd(x) nach der genannten Vorschrift gewählt werden soll, wobei AND einer logischen UND-Operation des Eintrages an der durch Rechtsverschiebung (BSR-Funktion) um die Anzahl nbit-1 Bitstellen der Integer-Zahl int(x) bestimmten Bitstelle mit dem Integerwert "1" entspricht.

6. Verfahren nach Anspruch 5, wobei die Rundungsoperation nach folgender Vorschrift durchgeführt wird:

$$comp(x) = BSR(int(x), nbit)+rnd(x),$$

wobei comp(x) der durch die Rundung entstehende auflösungsreduzierte Anteil der Integer-Zahl int(x) entspricht, wobei nbit der Angabe entspricht um wie viele Bitstellen die Integer-Zahl nach rechts verschoben werden soll, bevor die Addition mit der Rundungsinformation rnd(x) durchgeführt wird.

7. Verfahren nach Anspruch 6, wobei für den Schritt der Dezimierung der Zeitreihen-Datenelemente (DP(0) - DP(n-1)) die gerundeten Werte comp(x) und comp(x-1) miteinander verglichen werden und ein nachfolgender identischer Wert comp(x) aus der Zeitreihe weggelassen wird.

8. Verfahren nach Anspruch 6 oder 7, wobei eine Box-Plot-Analyse des komprimierten Datensatzes (DS) durchgeführt wird, indem die dezimierte Zeitreihe nach aufsteigender Größe der auflösungsreduzierten comp(x)-Information sortiert wird und die Kennwerte der Box-Plot-Analyse, insbesondere Minimumwert, Maximalwert, Medianwert, unteres Quartil und oberes Quartil unter Berücksichtigung der Zeitdifferenz zum jeweils nächsten Datenelement (DP(0) - DP(n-1)) aus dem komprimierten Datensatz (DS) bestimmt werden.

9. Vorrichtung zur Durchführung des Verfahrens nach einem der vorhergehenden Ansprüche, aufweisend wenigstens eine Recheneinheit (142), die ausgelegt ist, zu aufeinanderfolgenden Zeitpunkten eine Messwerterfassung wenigstens eines angeschlossenen Sensors durchzuführen oder die vom Sensor (171, 172, 173) erfassten Messwerte zu empfangen, wobei die Recheneinheit (142) ausgelegt ist, mit den Messwerten und zugehörigen Messzeitpunkten eine Zeitreihe zu bilden, und wobei die Recheneinheit (142) ausgelegt ist, wenigstens den Schritt einer Rundung mit einer nachfolgenden Dezimierung der in der wenigstens einen Zeitreihe enthaltenen Datenelemente (DP(0) - DP(n-1)) des Datensatzes (DS) durchzuführen und die dezimierte Zeitreihe des Datensatzes (DS) in der Recheneinheit abzuspeichern und/oder an eine externe Recheneinrichtung zu übertragen, wobei der Schritt der Dezimierung es beinhaltet, dass die Änderung der gerundeten Daten der Datenelemente (DP(0) - DP(n-1)) der Zeitreihe untersucht wird, und diejenigen Datenelemente (DP(x)) entfernt werden, bei denen die gerundeten Werte gleich den gerundeten Werten des jeweils zeitlich direkt benachbarten Vorgängerdatenelements (DP(x-1)) sind.

10. Vorrichtung nach Anspruch 9, wobei die Recheneinrichtung (142) oder eine weitere Recheneinrichtung (40) ausgelegt ist, eine Box-Plot-Analyse des komprimierten Datensatzes (DS) durchzuführen, indem die dezimierte Zeitreihe nach aufsteigender Größe der auflösungsreduzierten comp(x)-Information sortiert wird und die Kennwerte der Box-Plot-Analyse, insbesondere Minimumwert, Maximalwert, Medianwert, unteres Quartil und oberes Quartil, unter Berücksichtigung der Zeitdifferenz zum jeweils nächsten Datenelement (DP(0) - DP(n-1)) aus dem komprimierten Datensatz (DS) bestimmt werden.

11. Fahrzeug, **dadurch gekennzeichnet, dass** das Fahrzeug (10) eine Vorrichtung nach einem der Ansprüche 9 oder 10 aufweist.

12. Vorrichtung zur Durchführung des Verfahrens nach Anspruch 8, aufweisend wenigstens eine Recheneinrichtung (320), die ausgelegt ist den komprimierten Datensatz (DS) zu empfangen, **dadurch gekennzeichnet, dass** die Recheneinrichtung (320) ausgelegt ist, eine Box-Plot-Analyse des komprimierten Datensatzes (DS) durchzuführen, indem die dezimierte Zeitreihe nach aufsteigender Größe der auflösungsreduzierten comp(x)-Information sortiert wird und die Kennwerte der Box-Plot-Analyse, insbesondere Minimumwert, Maximalwert, Medianwert, unteres Quartil und oberes Quartil, unter Berücksichtigung der Zeitdifferenz zum jeweils nächsten Datenelement (DP(0) - DP(n-1)) aus dem komprimierten Datensatz (DS) bestimmt werden.

13. Computerprogramm, **dadurch gekennzeichnet, dass** das Computerprogramm ausgelegt ist, bei Abarbeitung in einer Recheneinheit (142) die Schritte des Verfahrens zur Aufbereitung von wenigstens eine Zeitreihe enthaltenden Datensätzen (DS) nach einem der Ansprüche 1 bis 8 durchzuführen.

## Claims

1. Method for processing data sets that contain at least one time series using a computing unit, wherein the time series contains the data (int(0) - int(n-1)) captured at specific time points and the corresponding time point (t(0) - t(n-1)) of the data capture as data elements (DP(0) - DP(n-1)), wherein a step of rounding the captured data (int(0) - int(n-1)) is performed with a subsequent decimation of the data elements (DP(0) - DP(n-1)) of the data set (DS) that are contained in the at least one time series, and the decimated time series of the data set (DS) is stored in the computing unit and/or transmitted to an external computing means, and wherein the decimation step includes examining the change in the rounded data of the data elements (DP(0) - DP(n-1)) of the time series and removing those data elements (DP(x)) where the rounded values are equal to the rounded values of the respective temporally directly adjacent predecessor data element (DP(x-1)).

2. Method according to claim 1, wherein the time series corresponds to a series of measurement values, wherein the measurement values are captured as integers or are captured as floating-point numbers and converted into integers (int(0) - int(n-1)).

3. Method according to claim 2, wherein, for the conversion of the floating-point numbers of the data elements (DP(0) - DP(n-1)) of the time series into integers (int(0) - int(n-1)), an offset "o" is subtracted and the result of the subtraction is divided by a factor "f".

4. Method according to claim 3, wherein, in preparation for decimating the data elements (DP(0) - DP(n-1)) of the time series, an algorithm is performed which is based on rounding the integers (int(0) - int(n-1)).

5. Method according to claim 4, wherein the rounding operation is prepared according to the following rule:

$$rnd(x) = AND(BSR(int(x), nbit-1), 1)$$

where rnd(x) corresponds to rounding information of the integer that is selected for a subsequent rounding operation, where x corresponds to a data element index, where int(x) corresponds to the integer, where nbit-1 specifies which bit position of the integer should be selected for calculating the rounding information rnd(x) according to the stated rule, where AND corresponds to a logical AND operation of the entry at the bit position with the integer value "1" that is determined by a right shift (BSR function) of the integer int(x) by nbit-1 bit positions.

6. Method according to claim 5, wherein the rounding operation is performed according to the following rule:

$$comp(x) = BSR(int(x), nbit)+rnd(x),$$

where comp(x) corresponds to the resolution-reduced part of the integer int(x) resulting from rounding, where nbit corresponds to the specification by how many bit positions the integer should be shifted to the right before the addition with the rounding information rnd(x) is performed.

7. Method according to claim 6, wherein, for the step of decimating the time series data elements (DP(0) - DP(n-1)), the rounded values comp(x) and comp(x-1) are compared with one another and a subsequent identical value comp(x) is omitted from the time series.

8. Method according to claim 6 or 7, wherein a box plot analysis of the compressed data set (DS) is performed by sorting the decimated time series according to ascending size of the resolution-reduced comp(x) information and determining the characteristic values of the box plot analysis, in particular a minimum value, maximum value, median value, lower quartile and upper quartile, taking into account the time difference to the respective next data element (DP(0) - DP(n-1)) from the compressed data set (DS).

9. Device for carrying out the method according to any of the preceding claims, comprising at least one computing unit (142) configured to perform measurement value acquisition from at least one connected sensor at successive time points or to receive the measurement values captured by the sensor (171, 172, 173), wherein the computing unit (142) is configured to form a time series using the measurement values and associated measurement time points, and wherein the computing unit (142) is configured to perform at least the step of rounding with a subsequent decimation of the data elements (DP(0) - DP(n-1)) of the data set (DS) that are contained in the at least one time series and to store the decimated time series of the data set (DS) in the computing unit and/or to transmit it to an external computing means, wherein the decimation step includes examining the change in the rounded data of the data elements (DP(0) - DP(n-1)) of the time series and removing those data elements (DP(x)) where the rounded values are equal to the rounded values of the respective temporally directly adjacent predecessor data element (DP(x-1)).

10. Device according to claim 9, wherein the computing means (142) or a further computing means (40) is configured to perform a box plot analysis of the compressed data set (DS) by sorting the decimated time series according to ascending size of the resolution-reduced comp(x) information and determining the characteristic values of the box plot analysis, in particular the minimum value, maximum value, median value, lower quartile and upper quartile, taking into account the time difference to the respective next data element (DP(0) - DP(n-1)) from the compressed data set (DS).

11. Vehicle **characterized in that** the vehicle (10) comprises a device according to either claim 9 or claim 10.

12. Device for carrying out the method according to claim 8, comprising at least one computing means (320) configured to receive the compressed data set (DS), **characterized in that** the computing means (320) is configured to perform a box plot analysis of the compressed data set (DS) by sorting the decimated time series according to ascending size of the resolution-reduced comp(x) information and determining the characteristic values of the box plot analysis, in particular the minimum value, maximum value, median value, lower quartile and upper quartile, taking into account the time difference to the respective next data element (DP(0) - DP(n-1)) from the compressed data set (DS).

13. Computer program **characterized in that,** when run in a computing unit (142), the computer program is configured to perform the steps of the method for processing data sets (DS) containing at least one time series according to any of claims 1 to 8.

**Revendications**

1. Procédé de préparation de jeux de données contenant au moins une série temporelle par une unité de calcul, dans lequel la série temporelle contient les données (int(0) - int(n-1)) acquises à des instants déterminés et l'instant (t(0) à t(n-1)) respectif de l'acquisition de données en tant qu'éléments de données (DP(0) à DP(n-1)), dans lequel une étape d'un arrondi des données (int(0) à int(n-1)) acquises est effectuée avec une décimation subséquente des éléments de données (DP(0) à DP(n-1)) du jeu de données (DS) contenus dans l'au moins une série temporelle et la série temporelle décimée du jeu de données (DS) est mémorisée dans l'unité de calcul et/ou transmise à un dispositif de calcul externe, et dans lequel l'étape de décimation contient l'examen de la modification des données arrondies des éléments de données (DP(0) à DP(n-1)) de la série temporelle, et l'élimination des éléments de données (DP(x)) pour lesquels les valeurs arrondies sont égales aux valeurs arrondies de l'élément de données précédent (DP(x-1)) directement voisin dans le temps.

2. Procédé selon la revendication 1, dans lequel la série temporelle correspond à une série de valeurs de mesure, dans lequel les valeurs de mesure sont acquises sous forme de nombres entiers ou sont acquises sous forme de nombres à virgule flottante et sont converties en nombres entiers (int(0) à int(n-1)).

3. Procédé selon la revendication 2, dans lequel, pour la conversion en nombres entiers (int(0) à int(n-1)), un décalage « o » est soustrait des nombres à virgule flottante des éléments de données (DP(0) à DP(n-1)) de la série temporelle et le résultat de la soustraction est divisé par un facteur « f ».

4. Procédé selon la revendication 3, dans lequel, pour préparer la décimation des éléments de données (DP(0) à DP(n-1)) de la série temporelle, un algorithme est exécuté, qui repose sur un arrondi des nombres entiers (int(0) à int(n-1)).

5. Procédé selon la revendication 4, dans lequel l'opération d'arrondi est préparée selon la règle suivante :

$$rnd(x) = AND(BSR(int(x), nbit-1), 1)$$

dans lequel rnd(x) correspond à une information d'arrondi du nombre entier qui est sélectionné pour une opération d'arrondi ultérieure, dans lequel x correspond à un index d'élément de données, dans lequel int(x) correspond au nombre entier, dans lequel nbit-1 indique quelle position de bit du nombre entier doit être sélectionnée pour le calcul de l'information d'arrondi rnd(x) selon la règle mentionnée, dans lequel AND correspond à une opération ET logique de l'entrée à la position binaire déterminée par décalage vers la droite (fonction BSR) du nombre nbit-1 de positions binaires du nombre entier int(x) avec la valeur entière « 1 ».

6. Procédé selon la revendication 5, dans lequel l'opération d'arrondi est réalisée selon la règle suivante :

$$comp(x) = BSR(int(x), nbit)+rnd(x),$$

dans lequel comp(x) correspond à la partie réduite en résolution du nombre entier int(x) résultant de l'arrondi, dans lequel nbit correspond à l'indication du nombre de bits dont le nombre entier doit être décalé vers la droite avant que l'addition soit réalisée avec l'information d'arrondi rnd(x).

7. Procédé selon la revendication 6, dans lequel, pour l'étape de décimation des éléments de données de série temporelle (DP(0) à DP(n-1)), les valeurs arrondies comp(x) et comp(x-1) sont comparées entre elles et une valeur identique suivante comp(x) est omise de la série temporelle.

8. Procédé selon la revendication 6 ou 7, dans lequel une analyse par diagramme de quartiles du jeu de données (DS) compressé est réalisée en triant la série temporelle décimée par taille croissante de l'information comp(x) réduite en résolution et en déterminant les valeurs caractéristiques de l'analyse par diagramme de quartiles, en particulier la valeur minimale, la valeur maximale, la valeur médiane, le quartile inférieur et le quartile supérieur en tenant compte de la différence de temps par rapport à l'élément de données (DP(0) à DP(n-1)) respectivement suivant à partir du jeu de données (DS) compressé.

9. Dispositif pour la réalisation du procédé selon l'une des revendications précédentes, présentant au moins une unité de calcul (142) qui est conçue pour réaliser à des instants successifs une acquisition de valeurs de mesure d'au moins un capteur raccordé ou pour recevoir les valeurs de mesure acquises par le capteur (171, 172, 173), dans lequel l'unité de calcul (142) est conçue pour former une série temporelle avec les valeurs de mesure et les instants de mesure associés, et dans lequel l'unité de calcul (142) est conçue pour réaliser au moins l'étape d'un arrondi suivi d'une décimation des éléments de données (DP(0) à DP(n-1)) du jeu de données (DS) contenus dans l'au moins une série temporelle et pour mémoriser la série temporelle décimée du jeu de données (DS) dans l'unité de calcul et/ou pour la transmettre à un dispositif de calcul externe, dans lequel l'étape de décimation contient l'examen de la modification des données arrondies des éléments de données (DP(0) à DP(n-1)) de la série temporelle, et l'élimination des éléments de données (DP(x)) pour lesquels les valeurs arrondies sont égales aux valeurs arrondies de l'élément de données précédent (DP(x-1)) directement voisin dans le temps.

10. Dispositif selon la revendication 9, dans lequel le dispositif de calcul (142) ou un autre dispositif de calcul (40) est conçu pour réaliser une analyse par diagramme de quartiles du jeu de données (DS) compressé en triant la série temporelle décimée par taille croissante de l'information comp(x) réduite en résolution et en déterminant les valeurs caractéristiques de l'analyse par diagramme de quartiles, en particulier la valeur minimale, la valeur maximale, la valeur médiane, le quartile inférieur et le quartile supérieur compressé en tenant compte de la différence de temps par rapport à l'élément de données (DP(0) à DP(n-1)) respectivement suivant à partir du jeu de données (DS) compressé.

11. Véhicule, **caractérisé en ce que** le véhicule (10) présente un dispositif selon l'une des revendications 9 ou 10.

12. Dispositif pour la réalisation du procédé selon la revendication 8, présentant au moins un dispositif de calcul (320) qui est conçu pour recevoir le jeu de données (DS) compressé, **caractérisé en ce que** le dispositif de calcul (320) est conçu pour réaliser une analyse par diagramme de quartiles du jeu de données (DS) compressé, en triant la série temporelle décimée par taille croissante de l'information comp(x) réduite en résolution et en déterminant les valeurs caractéristiques de l'analyse par diagramme de quartiles, en particulier la valeur minimale, la valeur maximale, la valeur médiane, le quartile inférieur et le quartile supérieur, en tenant compte de la différence de temps par rapport à l'élément de données (DP(0) - DP(n-1)) respectivement suivant à partir du jeu de données (DS) compressé.

13. Programme d'ordinateur, **caractérisé en ce que** le programme d'ordinateur est conçu pour réaliser, lors de son exécution dans une unité de calcul (142), les étapes du procédé de préparation de jeux de données (DS) contenant au moins une série temporelle selon l'une des revendications 1 à 8.

Fig. 1

Fig. 2

Fig. 3

EP 4 115 528 B1

Fig. 4

EP 4 115 528 B1

Fig. 5

| Index „x" | 0 | 1 | 2 | 3 | 4 | 5 | 6 | 7 | 8 |
|-----------|---|---|---|---|---|---|---|---|---|
| t(x) | 0 | 10 | 20 | 30 | 40 | 50 | 60 | 70 | 80 |
| int(x) „DEC" | 0 | 1 | 0 | 3 | 5 | 8 | 5 | 4 | 5 |
| fp(x) | 0.0 | 0.01 | 0.0 | 0.03 | 0.05 | 0.08 | 0.05 | 0.04 | 0.05 |

Fig. 6

Fig. 7

| DEC | BIN | | | | DEC | DEC |
|-----|---|---|---|---|-----|------|
| „int" | „int" | | | | „rnd" | „comp" |
| 0 | 0 | 0 | 0 | 0 | 0 | 0 |
| 1 | 0 | 0 | 0 | 1 | 0 | 0 |
| 2 | 0 | 0 | 1 | 0 | 1 | 1 |
| 3 | 0 | 0 | 1 | 1 | 1 | 1 |
| 4 | 0 | 1 | 0 | 0 | 0 | 1 |
| 5 | 0 | 1 | 0 | 1 | 0 | 1 |
| 6 | 0 | 1 | 1 | 0 | 1 | 2 |
| 7 | 0 | 1 | 1 | 1 | 1 | 2 |
| 8 | 1 | 0 | 0 | 0 | 0 | 2 |
| ... | ... | | | | ... | ... |

rnd

**Fig. 8**

| Index „x" | 0 | 1 | 2 | 3 | 4 | 5 | 6 | 7 | 8 |
|-----------|---|---|---|---|---|---|---|---|---|
| t(x) | 0 | 10 | 20 | 30 | 40 | 50 | 60 | 70 | 80 |
| int(x) „DEC" | 0 | 1 | 0 | 3 | 5 | 8 | 5 | 4 | 5 |
| comp(x) | 0 | 0 | 0 | 1 | 1 | 2 | 1 | 1 | 1 |
| zuletzt | 0 | | | 1 | | 2 | 1 | | |
| Tx | x | | | x | | x | x | | |

**Fig. 9**

| Index „c" | 0 | 1 | 2 | 3 |
|-----------|---|----|----|----|
| t(c) | 0 | 30 | 50 | 60 |
| comp(c) | 0 | 1 | 2 | 1 |
| fp(c) | 0 | 0.04 | 0.08 | 0.04 |

**Fig. 10**

24

Fig. 11

Fig. 12

| Index „x" | fp(x) | Bezeichnung |
|-----------|-------|-------------|
| 0 | 0.0 | min |
| 2 | 0.0 | - |
| 1 | 0.01 | Q25 |
| 3 | 0.03 | - |
| 7 | 0.04 | Median |
| 4 | 0.05 | - |
| 6 | 0.05 | Q75 |
| 5 | 0.08 | Max |

## Fig. 13

Fig. 14

| Index „c" | dt | rt | comp(c) | Bezeichnung | fp(c) |
|-----------|-----|-------|---------|-------------|-------|
| 0 | 30 | 37,5% | 0 | min, Q25 | 0.0 |
| 1 | 20 | 50% | 1 | Median, Q75 | 0.04 |
| 3 | 20 | | 1 | | |
| 2 | 10 | 12,5% | 2 | Max | 0.08 |

**Fig. 15**

fp(rt) sortiert

BPCS

**Fig. 16**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2018253559 A1
- US 9520894 B1
- EP 2645318 A1
- EP 3522577 A1